(19) Europäisches Patentamt / European Patent Office / Office européen des brevets

(11) **EP 4 551 955 B1**

(12) **FASCICULE DE BREVET EUROPEEN**

(45) Date de publication et mention de la délivrance du brevet:
**02.07.2025  Bulletin 2025/27**

(21) Numéro de dépôt: **23793440.1**

(22) Date de dépôt: **06.10.2023**

(51) Classification Internationale des Brevets (IPC):
**G01R 31/28** *(2006.01)*

(52) Classification Coopérative des Brevets (CPC):
**F03H 1/0018; G01R 31/2846;** G01R 31/2818

(86) Numéro de dépôt international:
**PCT/FR2023/051557**

(87) Numéro de publication internationale:
**WO 2024/079414 (18.04.2024 Gazette 2024/16)**

(54) **DISPOSITIF DE TEST D'UN ENSEMBLE D'ALIMENTATION ELECTRIQUE POUR PROPULSEUR IONIQUE A GRILLES**

VORRICHTUNG ZUM TESTEN EINER STROMVERSORGUNGSANORDNUNG FÜR EIN GERASTERTES IONENTRIEBWERK

DEVICE FOR TESTING AN ELECTRICAL POWER SUPPLY ASSEMBLY FOR A GRIDDED ION THRUSTER

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **12.10.2022  FR 2210452**

(43) Date de publication de la demande:
**14.05.2025  Bulletin 2025/20**

(73) Titulaire: **Airbus Defence and Space SAS
31402 Toulouse Cedex 4 (FR)**

(72) Inventeurs:
• **NICOLAS, Dominique**
  **31402 Toulouse Cedex 4 (FR)**
• **KIRCH, Paul**
  **31402 Toulouse Cedex 4 (FR)**

(74) Mandataire: **Plasseraud IP
104 Rue de Richelieu
CS92104
75080 Paris Cedex 02 (FR)**

(56) Documents cités:
CN-A- 104 330 661     CN-B- 108 535 607
CN-U- 208 076 158

• YANHUI JIA ET AL: "2D hybrid-PIC simulation of the two and three-grid system of ion thruster", PLASMA SCIENCE AND TECHNOLOGY, INSTITUTE OF PHYSICS PUBLISHING, BRISTOL, GB, vol. 20, no. 10, 20 August 2018 (2018-08-20), pages 105502, XP020330921, ISSN: 1009-0630, [retrieved on 20180820], DOI: 10.1088/2058-6272/ AACE52
• HOLSTE K ET AL: "Ion thrusters for electric propulsion: Scientific issues developing a niche technology into a game changer", REVIEW OF SCIENTIFIC INSTRUMENTS, AMERICAN INSTITUTE OF PHYSICS, 2 HUNTINGTON QUADRANGLE, MELVILLE, NY 11747, vol. 91, no. 6, 24 June 2020 (2020-06-24), XP012248054, ISSN: 0034-6748, [retrieved on 20200624], DOI: 10.1063/5.0010134

**Description**

**Domaine technique**

La présente description concerne un dispositif permettant de tester un ensemble d'alimentation électrique pour propulseur ionique à grilles, ainsi qu'un procédé de test qui est réalisé en utilisant le dispositif. Dans le domaine technique de la propulsion des véhicules spatiaux, un tel ensemble d'alimentation électrique est couramment désigné par PPU, pour «Power Processing Unit» en anglais.

**Technique antérieure**

Des propulseurs ioniques à grilles sont utilisés dans des véhicules spatiaux tels que des satellites ou des sondes spatiales, pour produire la poussée de propulsion du véhicule spatial. Ces propulseurs ioniques à grilles peuvent être du type à décharge continue, désigné par l'acronyme GIT pour «Gridded-Ion Thruster» en anglais et aussi appelé type Kaufman ou «ring cusp», ou bien du type à décharge radiofréquence, désigné par l'acronyme RIT pour «Radiofrequency Ion Thruster». Ainsi, au moins un propulseur ionique à grilles peut être embarqué à bord d'un véhicule spatial, avec un ensemble d'alimentation électrique qui est destiné à fournir à ce propulseur des tensions et courants électriques appropriés pour que ce dernier produise la poussée de propulsion désirée.

Il est alors nécessaire de vérifier le bon fonctionnement de l'ensemble d'alimentation électrique, non seulement pour que cet ensemble soit capable d'alimenter électriquement le propulseur afin de produire une poussée désirée, mais aussi pour que l'ensemble d'alimentation électrique soit capable de réaliser un test du propulseur qui caractérise une évolution de celui-ci au cours de sa durée d'utilisation à bord du véhicule spatial. En effet, de multiples mécanismes d'usure et de vieillissement affectent le propulseur ionique à grilles pendant sa durée d'utilisation, en altérant progressivement ses caractéristiques. Cette usure ou vieillissement est surveillé(e) et caractérisé(e) pendant que le véhicule spatial est dans l'espace extraterrestre, en faisant réaliser répétitivement un test du propulseur par son ensemble d'alimentation électrique. Les résultats de ce test permettent d'ajuster au moins un point de fonctionnement à utiliser pour le propulseur. Ils permettent aussi de gérer une vitesse de vieillissement du propulseur dans sa durée d'utilisation restante, et notamment d'établir des compromis entre un ralentissement de ce vieillissement et des fonctionnements qui sont plus performants pour la mission du véhicule spatial, mais qui provoquent une usure plus rapide.

Le document US 6,964,396 B2 décrit de réaliser un test de type EBS, pour «Electron Back-Streaming» en anglais ou mesure de rétro-circulation d'électrons, mais ce test est réalisé à bord du véhicule spatial lorsqu'il est dans l'espace extraterrestre.

Pour tester l'ensemble PPU d'alimentation électrique et le propulseur ionique sur Terre, il est nécessaire de connecter le propulseur ionique à grilles à cet ensemble PPU d'alimentation électrique, et de faire fonctionner le propulseur. Pour cela, le propulseur doit être enfermé dans une enceinte à vide qui est capable de reproduire au mieux les conditions environnementales de l'espace extraterrestre. Mais ces exigences opératoires sont très contraignantes, notamment parce qu'elles nécessitent de disposer du propulseur et de l'enceinte à vide pour tester l'ensemble d'alimentation électrique. En outre, l'ensemble d'alimentation électrique est testé en général au moins deux fois sur Terre, avant qu'il soit intégré au véhicule spatial, et après que cette intégration a été effectuée. Ces tests font partie de la procédure AIT, pour Assemblage-Intégration-Tests dans le jargon de l'Homme du métier.

CN 104 330 661 A concerne un dispositif de simulation des caractéristiques de charge d'un propulseur ionique de type Kaufmann.

**Problème technique**

L'invention a alors pour but de répondre à ce besoin de tester sur Terre l'ensemble PPU d'alimentation électrique d'un propulseur ionique à grilles, d'une façon qui soit plus facile qu'en mettant en œuvre un fonctionnement du propulseur.

Plus particulièrement, l'invention a pour but de permettre de tester un ensemble d'alimentation électrique pour propulseur ionique à grilles, sans qu'il soit nécessaire de disposer du propulseur ni de le mettre dans des conditions opératoires qui reproduisent l'environnement extraterrestre.

Notamment, l'invention a pour but de vérifier, au sol, la capacité d'un ensemble d'alimentation électrique pour propulseur ionique à grilles à appliquer un test de type EBS au propulseur.

**Résumé de l'invention**

Pour atteindre ce but ou un autre, un premier aspect de l'invention propose un dispositif électrique qui est destiné à se comporter comme un propulseur ionique à grilles lorsque le dispositif est connecté électriquement, par des bornes de ce dispositif, à un ensemble d'alimentation électrique de pilotage du propulseur, le dispositif comprenant au moins :

- une première borne pour recevoir une tension électrique positive fournie par l'ensemble d'alimentation électrique, et destinée à remplacer une borne d'alimentation d'une grille d'écran du propulseur ;
- une deuxième borne pour recevoir une tension électrique négative fournie par l'ensemble d'alimentation électrique, et destinée à remplacer une borne d'alimentation d'une grille d'accélération du propulseur ;
- une troisième borne pour transmettre à un nœud commun de référence de l'ensemble d'alimentation électrique, un courant de retour provenant du dispositif, et destinée à remplacer une borne de retour de courant d'un neutraliseur du propulseur qui a pour fonction de générer un flux d'électrons de neutralisation de faisceau ionique lors d'un fonctionnement du propulseur, le nœud commun de référence formant une référence de potentiel électrique pour la tension électrique positive et pour la tension électrique négative ;
- une quatrième borne pour recevoir un courant de maintien de neutraliseur provenant de l'ensemble d'alimentation électrique, et destinée à remplacer une borne d'un système de maintien du neutraliseur du propulseur ayant pour fonction de maintenir une température de ce neutraliseur lors du fonctionnement du propulseur ;
- une résistance de simulation de maintien de neutraliseur, qui est connectée entre les troisième et quatrième bornes du dispositif ;
- au moins deux cinquièmes bornes pour recevoir une puissance de décharge qui est fournie par un étage d'alimentation de décharge de l'ensemble d'alimentation électrique, et destinées à remplacer au moins en partie des bornes du propulseur qui sont dédiées à recevoir la puissance de décharge pour générer un plasma ayant une fonction de source d'ions lors du fonctionnement du propulseur ;
- une unité de mesure, agencée pour mesurer la puissance de décharge reçue ;
- une première source de courant dépendante, qui possède une borne positive connectée à la première borne du dispositif et une borne négative connectée à la troisième borne du dispositif, la première source de courant dépendante étant destinée à fixer un courant de faisceau qui s'écoule à travers cette première source de courant dépendante de sa borne positive vers sa borne négative ;
- une seconde source de courant dépendante, qui possède une borne positive connectée à la première borne du dispositif et une borne négative connectée à la deuxième borne du dispositif, la seconde source de courant dépendante étant destinée à fixer un courant de grille d'accélération qui s'écoule à travers cette seconde source de courant dépendante de sa borne positive vers sa borne négative ; et
- un condensateur, qui est connecté entre les bornes positive et négative de la seconde source de courant dépendante.

Selon une caractéristique supplémentaire du dispositif de l'invention, il est configuré pour déterminer, lorsque le dispositif est alimenté électriquement et connecté à l'ensemble d'alimentation électrique, le courant de faisceau en fonction de la puissance de décharge mesurée par l'unité de mesure et en fonction d'au moins un paramètre de configuration du dispositif, et pour déterminer en outre le courant de grille d'accélération en fonction du courant de faisceau et en fonction d'au moins un autre paramètre de configuration du dispositif.

Un tel dispositif est capable d'imiter le fonctionnement électrique du propulseur lorsque ce dispositif est connecté à l'ensemble d'alimentation électrique à la place du propulseur, tel que ce fonctionnement du propulseur serait effectif pour l'ensemble d'alimentation électrique. Le fonctionnement de l'ensemble d'alimentation électrique peut ainsi être testé, tel qu'il serait effectif pour que le propulseur produise une poussée de propulsion, ou tel qu'il serait effectif pour réaliser un test du propulseur, par exemple un test de type EBS. En connectant le dispositif à la place du propulseur à l'ensemble d'alimentation électrique, il devient inutile de reproduire des conditions d'environnement extraterrestre pour permettre le fonctionnement du propulseur. L'ensemble d'alimentation électrique peut ainsi être testé beaucoup plus facilement, éventuellement sans que le propulseur soit encore disponible. Les conditions opératoires et la logistique qui sont nécessaires pour tester l'ensemble d'alimentation électrique sont ainsi beaucoup plus simples.

En outre, le dispositif peut être utilisé pour tester l'ensemble d'alimentation électrique aussi bien avant que ce dernier soit intégré à un véhicule spatial, ou après qu'il y a été intégré.

Un dispositif conforme à l'invention peut être réalisé à partir de composants et appareils électriques qui sont disponibles commercialement, et pour un prix de revient qui est limité.

Avantageusement, le condensateur qui est connecté entre les bornes positive et négative de la seconde source de courant dépendante, peut être destiné à simuler une capacité d'interaction qui existe entre la grille d'écran et la grille d'accélération du propulseur. Dans ce cas, ce condensateur possède une valeur de capacité qui peut être déterminée en additionnant les trois contributions suivantes :

- une première contribution qui correspond à des faces respectives de la grille d'écran et la grille d'accélération du propulseur qui sont en vis-à-vis ;
- une deuxième contribution qui correspond à une capacité de frange de la grille d'écran du propulseur, existant entre la grille d'accélération et des surfaces latérales de trous de la grille d'écran ; et
- une troisième contribution qui correspond à une capacité de frange de la grille d'accélération du propulseur, existant entre la grille d'écran et des surfaces latérales de trous de la grille d'accélération.

Selon un premier perfectionnement du dispositif, il peut comprendre en outre :

- une borne de masse électrique, qui est destinée à être connectée à une masse électrique de l'ensemble d'alimentation électrique à la place d'une borne de masse électrique du propulseur ; et
- une source électrique additionnelle, qui possède une première borne connectée à la troisième borne du dispositif, et une seconde borne connectée à la borne de masse électrique du dispositif, pour produire pendant un fonctionnement du dispositif, un courant électrique destiné à imiter un courant de fuite qui se produit dans le propulseur lors du fonctionnement de celui-ci, le dispositif étant configuré pour activer ou désactiver la source électrique additionnelle conformément à un état d'activation ou de désactivation, respectivement, de la première source de courant dépendante.

Le dispositif peut ainsi produire une meilleure imitation du fonctionnement du propulseur ionique à grilles, telle que cette imitation est effective pour l'ensemble d'alimentation électrique.

Selon un second perfectionnement du dispositif, il peut comprendre en outre un contrôleur des première et seconde sources de courant dépendantes, ce contrôleur étant configuré de sorte que la première source de courant dépendante fixe le courant de faisceau conformément à la première fonction de transfert suivante : $I_{beam} = K_{beam} \cdot P_{ion}$ si la tension électrique positive qui est reçue sur la première borne du dispositif est supérieure à un seuil d'extraction d'ions $V_{PHVextr}$, et $I_{beam} = 0\ A$ (ampère) sinon, où $I_{beam}$ désigne le courant de faisceau fixé par la première source de courant dépendante, $P_{ion}$ désigne la puissance de décharge reçue par les cinquièmes bornes du dispositif et mesurée par l'unité de mesure, le seuil d'extraction d'ions $V_{PHVextr}$ étant un premier paramètre de configuration du dispositif, et $K_{beam}$ étant un coefficient. Le contrôleur est alors aussi configuré de sorte que la seconde source de courant dépendante fixe le courant de grille d'accélération conformément à la seconde fonction de transfert suivante : $I_{NHV} = I_{beam}/\beta$, où $I_{NHV}$ désigne le courant de grille d'accélération fixé par la seconde source de courant dépendante et $\beta$ est un autre coefficient qui constitue un deuxième paramètre de configuration du dispositif. Ces deux fonctions de transfert procurent une imitation du fonctionnement du propulseur qui est assez juste, telle que cette imitation est effective pour l'ensemble d'alimentation électrique.

De préférence, le contrôleur des première et seconde sources de courant dépendantes peut être configuré en outre pour déterminer le coefficient $K_{beam}$ selon la formule suivante : $K_{beam} = K_{beam0} \cdot \{1 + [\exp(V_{NHV} - V_{NHVchange})]/100\}$ si ce coefficient $K_{beam}$ est inférieur à une valeur maximale de coefficient $K_{beammax}$, et $K_{beam} = K_{beammax}$ sinon, où $\exp[\ ]$ désigne une fonction exponentielle, $V_{NHV}$ est la tension électrique négative qui est reçue sur la deuxième borne du dispositif, exprimée en volts, et la valeur maximale de coefficient $K_{beammax}$, ainsi que $K_{beam0}$ et $V_{NHVchange}$ exprimé en volts sont des paramètres supplémentaires de configuration du dispositif. Une imitation du fonctionnement du propulseur qui est encore plus juste peut ainsi être procurée par le dispositif à l'ensemble d'alimentation électrique.

Dans des premières réalisations de l'invention, pour lesquelles le dispositif est destiné à remplacer un propulseur de type GIT, les cinquièmes bornes peuvent comprendre au moins :

- une borne d'alimentation en courant de décharge, destinée à remplacer une borne d'anode d'une enceinte à plasma du propulseur où est généré le plasma ayant la fonction de source d'ions lors du fonctionnement du propulseur ; et
- une borne de retour de courant, destinée à remplacer une borne du propulseur qui transmet à l'ensemble d'alimentation électrique un courant de retour de cathode provenant d'une cathode de l'enceinte à plasma du propulseur.

Le dispositif comprend alors en outre :

- une résistance de simulation de l'enceinte à plasma du propulseur, qui est connectée entre la borne d'alimentation en courant de décharge et la borne de retour de courant.

Dans ce cas d'imitation d'un propulseur GIT, l'unité de mesure peut être adaptée pour mesurer un courant de décharge qui est reçu par le dispositif par la borne d'alimentation en courant de décharge, et pour mesurer une tension qui existe entre des extrémités de la résistance de simulation de l'enceinte à plasma du propulseur, et pour calculer une valeur de la puissance de décharge reçue à partir de valeurs mesurées respectivement pour le courant de décharge et pour la tension qui existe entre les extrémités de la résistance de simulation de l'enceinte à plasma du propulseur.

Possiblement, encore lorsque le dispositif est destiné à remplacer un propulseur de type GIT, les cinquièmes bornes peuvent comprendre en outre :

- deux bornes de simulation de chauffage de cathode, reliées entre elles par une première résistance additionnelle à l'intérieur du dispositif, et destinées à remplacer deux bornes du propulseur qui sont dédiées à alimenter lors du fonctionnement du propulseur, une résistance de chauffage de la cathode de l'enceinte à plasma du propulseur ayant la fonction de source d'ions ;

- une borne de simulation de cathode, reliée à la borne de retour de courant par une seconde résistance additionnelle à l'intérieur du dispositif, et destinée à remplacer une borne du propulseur qui est dédiée à alimenter avec un courant de maintien de cathode lors du fonctionnement du propulseur, un système de maintien associé à la cathode de l'enceinte à plasma du propulseur, supplémentaire par rapport à l'anode de l'enceinte à plasma et ayant pour fonction de maintenir une température de la cathode pendant le fonctionnement du propulseur ; et
- deux bornes de simulation de confinement magnétique, reliées entre elles à l'intérieur du dispositif par une bobine qui est associée à un élément ferromagnétique, et destinées à remplacer deux bornes du propulseur qui sont dédiées à alimenter lors du fonctionnement du propulseur, un système de confinement magnétique de l'enceinte à plasma dudit propulseur ayant la fonction de source d'ions.

Une imitation plus complète du fonctionnement du propulseur peut ainsi être produite par le dispositif.

Dans des secondes réalisations de l'invention, pour lesquelles le dispositif est destiné à remplacer un propulseur de type RIT, les cinquièmes bornes du dispositif peuvent comprendre deux bornes d'alimentation en radiofréquence, qui sont destinées à être connectées à deux bornes de sortie d'un générateur radiofréquence de l'ensemble d'alimentation électrique, pour remplacer deux bornes d'une bobine d'excitation de l'enceinte à plasma du propulseur. Le dispositif comprend alors en outre une bobine et une résistance de simulation d'enceinte à plasma qui sont connectées en série entre ses deux bornes d'alimentation en radiofréquence, et qui sont destinées à simuler la bobine d'excitation de l'enceinte à plasma du propulseur et un comportement électrique du plasma ayant la fonction de source d'ions lors du fonctionnement du propulseur.

Dans cet autre cas d'imitation d'un propulseur RIT, l'unité de mesure peut être adaptée pour mesurer un courant radiofréquence qui est reçu par le dispositif par ses deux bornes d'alimentation en radiofréquence, et pour mesurer une tension qui existe dans la résistance de simulation d'enceinte à plasma, et pour calculer une valeur de la puissance de décharge reçue à partir de valeurs mesurées respectivement pour le courant radiofréquence et pour la tension qui existe dans la résistance de simulation d'enceinte à plasma.

Un second aspect de l'invention propose un procédé de test d'un ensemble d'alimentation électrique, cet ensemble d'alimentation électrique étant adapté pour être connecté à un propulseur ionique à grilles pour fournir au propulseur des tensions et courants électriques pendant un fonctionnement de ce propulseur, le procédé de test comprenant les étapes suivantes :

/1/ collecter au moins un paramètre caractéristique du propulseur ;
/2/ reproduire l'au moins un paramètre caractéristique du propulseur dans un dispositif qui est conforme au premier aspect de l'invention, et configurer le dispositif de sorte qu'il imite un fonctionnement du propulseur ;
/3/ connecter l'ensemble d'alimentation électrique au dispositif ;
/4/ activer l'ensemble d'alimentation électrique afin que le dispositif imite le fonctionnement du propulseur pour l'ensemble d'alimentation électrique, et réaliser, au moyen de l'ensemble d'alimentation électrique, au moins une mesure d'une tension ou d'un courant électrique qui est fourni au dispositif par cet ensemble d'alimentation électrique ; et
/5/ d'après un résultat de la mesure, valider un fonctionnement de l'ensemble d'alimentation électrique, ou déclarer un dysfonctionnement de cet ensemble d'alimentation électrique.

Ce procédé de test est exécuté sur Terre avant ou après que l'ensemble d'alimentation électrique a été intégré à un véhicule spatial qui est destiné à être équipé du propulseur, quel que soit le type de ce véhicule spatial, par exemple un satellite ou sonde spatiale. Notamment, le procédé de test peut être exécuté dans des conditions ambiantes de pression et de température sur Terre, ou alors que l'ensemble d'alimentation électrique est placé dans des conditions de pression et de température qui reproduisent celles de l'espace extraterrestre.

En particulier, l'au moins un paramètre caractéristique du propulseur qui est collecté à l'étape /1/ peut comprendre une valeur de capacité d'interaction qui existe entre sa grille d'écran et sa grille d'accélération, cette valeur de capacité d'interaction étant déterminée en additionnant les trois contributions suivantes :

- une première contribution qui correspond à des faces respectives de la grille d'écran et la grille d'accélération du propulseur qui sont en vis-à-vis ;
- une deuxième contribution qui correspond à une capacité de frange de la grille d'écran du propulseur, telle qu'existant entre la grille d'accélération et des surfaces latérales de trous de la grille d'écran ; et
- une troisième contribution qui correspond à une capacité de frange de la grille d'accélération du propulseur, telle qu'existant entre la grille d'écran et des surfaces latérales de trous de la grille d'accélération.

Le dispositif peut alors être dimensionné en attribuant la valeur de capacité d'interaction ainsi calculée au condensateur du dispositif qui est connecté entre les bornes positive et négative de la seconde source de courant dépendante.

Le procédé de test du second aspect de l'invention peut être de type EBS, pour vérifier la capacité de l'ensemble d'alimentation électrique à soumettre le propulseur à un tel test. Pour cela, l'ensemble d'alimentation électrique peut comprendre un dispositif d'asservissement de la puissance de décharge, ce dispositif d'asservissement étant conçu pour ajuster cette puissance de décharge de façon à maintenir constante une valeur de différence entre un courant électrique qui entre dans le dispositif par sa première borne et un autre courant électrique qui sort du dispositif par sa seconde borne. L'étape /4/ du procédé de test est alors exécutée pendant que la valeur de différence est maintenue constante par le dispositif d'asservissement, et elle comprend d'adopter, par l'ensemble d'alimentation électrique, des valeurs variables successives pour la tension électrique négative qui sont croissantes alors que la tension électrique positive est gardée constante, et une valeur de la puissance de décharge est mesurée par l'ensemble d'alimentation électrique pour chaque valeur adoptée pour la tension électrique négative. L'étape /5/ comprend ensuite de vérifier un profil de variation des valeurs mesurées pour la puissance de décharge en fonction des valeurs variables de la tension électrique négative.

Pour réaliser un tel test de type EBS, l'ensemble d'alimentation électrique peut être configuré pour arrêter, à l'étape /4/, une séquence des valeurs variables successives qui sont adoptées pour la tension électrique négative si une réduction de la puissance de décharge par rapport à une valeur maximale de cette puissance de décharge qui a été atteinte pendant la séquence, devient supérieure à une valeur limite de réduction.

Notamment, lorsqu'une valeur du paramètre supplémentaire de configuration $V_{NHVchange}$ a été entrée dans le dispositif à l'étape /2/, la tension électrique négative peut être variée à l'étape /4/ par l'ensemble d'alimentation électrique en adoptant des valeurs successives qui sont de moins en moins négatives pour cette tension électrique négative. L'étape /5/ peut alors comprendre les sous-étapes suivantes :

/5-1/ déterminer, d'après les valeurs mesurées pour la puissance de décharge, une valeur de seuil pour la tension électrique négative qui correspond à un coude dans une courbe des valeurs mesurées pour cette puissance de décharge en fonction des valeurs croissantes de la tension électrique négative, du côté des valeurs les moins négatives de la tension électrique négative ; puis

/5-2/ comparer la valeur de seuil déterminée à la sous-étape /5-1/ à la valeur du paramètre supplémentaire de configuration $V_{NHVchange}$, et valider le fonctionnement de l'ensemble d'alimentation électrique si cette valeur de seuil correspond à la valeur du paramètre supplémentaire de configuration $V_{NHVchange}$ conformément à un critère de concordance, sinon déclarer le dysfonctionnement de l'ensemble d'alimentation électrique.

Le critère de concordance qui est utilisé à la sous-étape /5-2/ peut consister en ce qu'une valeur absolue d'une différence entre la valeur de seuil déterminée à la sous-étape /5-1/ et la valeur du paramètre supplémentaire de configuration $V_{NHVchange}$, divisée par une valeur absolue de cette dernière valeur, soit inférieure à 1%.

De façon générale, chaque paramètre caractéristique du propulseur et les paramètres de configuration qui sont utilisés pour le dispositif à l'étape /2/ d'un procédé de test conforme au second aspect de l'invention, peuvent concerner un propulseur ionique à grilles à décharge continue, c'est-à-dire de type GIT, ou un propulseur ionique à grilles à décharge radiofréquence, c'est-à-dire de type RIT.

**Brève description des figures**

Les caractéristiques et avantages de la présente invention apparaîtront plus clairement dans la description détaillée ci-après d'exemples de réalisation non-limitatifs, en référence aux figures annexées parmi lesquelles :

[Fig. 1] est diagramme qui montre un propulseur ionique à grilles de type GIT en situation de fonctionnement, en étant connecté à un ensemble d'alimentation électrique, tel que connu de l'art antérieur ;

[Fig. 2] correspond à [Fig. 1] pour un propulseur ionique à grilles de type RIT, aussi tel que connu de l'art antérieur ;

[Fig. 3] correspond à [Fig. 1] en remplaçant le propulseur ionique à grilles de type GIT par un premier dispositif conforme à l'invention ;

[Fig. 4] correspond à [Fig. 2] en remplaçant le propulseur ionique à grilles de type RIT par un second dispositif conforme à l'invention ; et

[Fig. 5] est un diagramme temporel qui montre un déroulement de test EBS réalisé avec un dispositif qui est conforme à l'invention.

## Description détaillée de l'invention

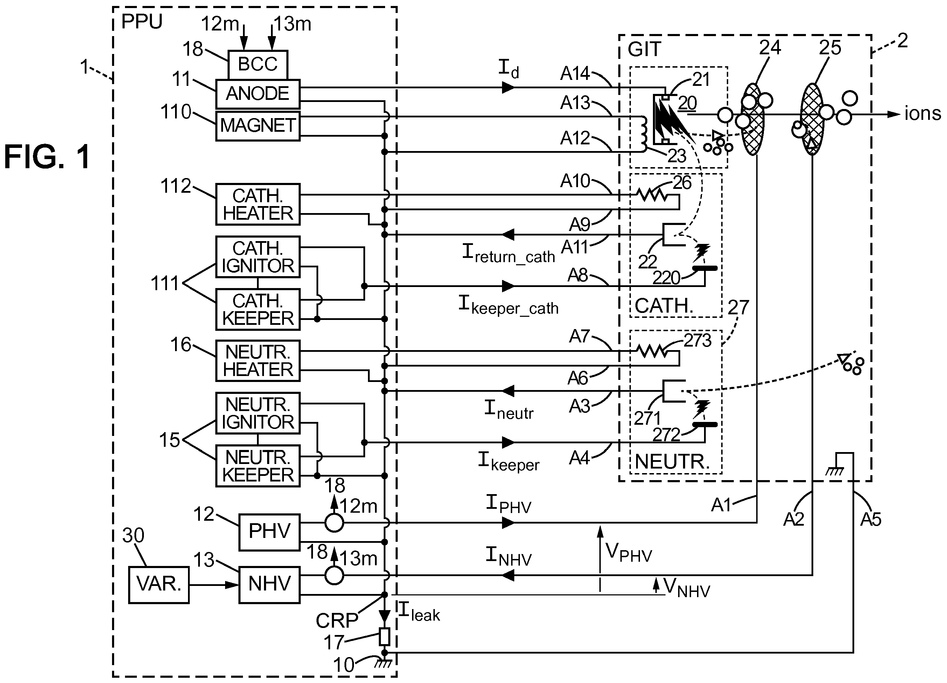

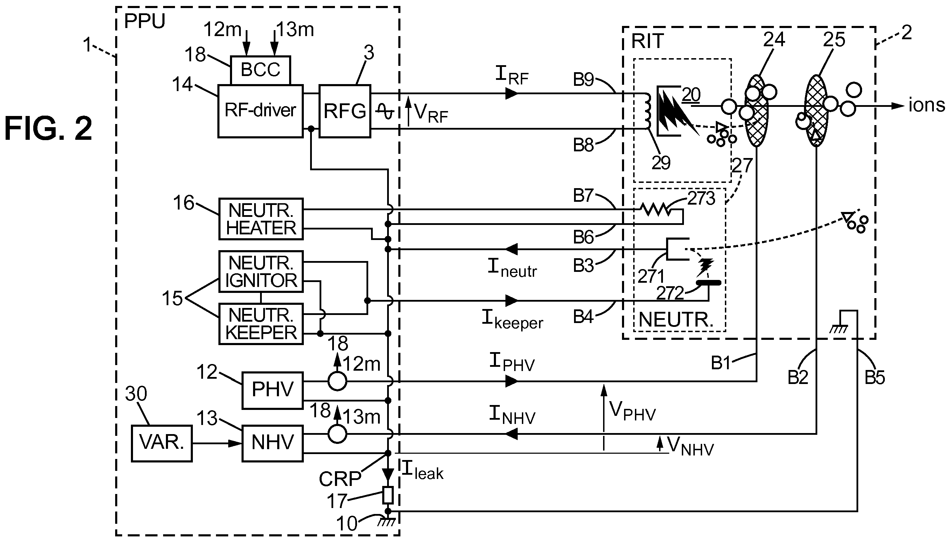

Dans ces figures, tous les éléments ne sont représentés que symboliquement, et des références identiques qui sont indiquées dans des figures différentes désignent des éléments identiques ou qui ont des fonctions identiques. En outre, pour raison de clarté de la présente description, les composants des ensembles d'alimentation électrique et des propulseurs qui sont décrits sont limités à ceux concernés par l'invention. En particulier, chacun des propulseurs ioniques à grilles de [Fig. 1] et [Fig. 2] comprend un système de gestion de gaz qui n'est pas représenté, et chaque ensemble d'alimentation électrique comprend des unités d'alimentation additionnelles et des interfaces dédiées au système de gestion de gaz, qui ne sont pas représentées non plus.

Dans [Fig. 1], la référence 1 désigne un ensemble d'alimentation électrique, communément désigné par l'acronyme PPU pour «Power Processing Unit» en anglais, et au moins un propulseur ionique à grilles 2 du type propulseur ionique à grilles à décharge continue, désigné par l'acronyme GIT pour «Gridded Ion Thruster». Le propulseur 2 est connecté électriquement à l'ensemble d'alimentation électrique 1 pour être alimenté électriquement par ce dernier, de façon à permettre un fonctionnement du propulseur. Ainsi, les différents composants du propulseur 2 sont alimentés en tensions et courants électriques par l'intermédiaire de l'ensemble d'alimentation électrique 1.

Le propulseur 2 de type GIT de [Fig. 1] comprend une enceinte à plasma 20, qui est munie d'une anode 21 et d'une cathode 22. L'anode 21 peut être située autour d'une ouverture de sortie de l'enceinte à plasma 20, par laquelle des ions sont destinés à sortir lors du fonctionnement du propulseur 2. Bien que cela n'apparaisse pas sur la figure pour raison de clarté de celle-ci, la cathode 22 peut être située au niveau du fond de l'enceinte à plasma 20, à l'opposé de son ouverture de sortie. L'enceinte à plasma 20 est munie d'un système de confinement magnétique 23, qui est couramment appelé «magnet». Ce système de confinement magnétique 23 est constitué par un électro-aimant dont la géométrie est appropriée pour confiner le plasma à l'intérieur de l'enceinte 20. Pour produire le plasma dans l'enceinte 20, et constituer ainsi une source des ions qui sont éjectés vers l'extérieur d'un véhicule spatial qui est destiné à être équipé du propulseur 2, une décharge électrique continue est générée dans l'enceinte 20 entre l'anode 21 et la cathode 22, en même temps qu'un gaz ionisable y est introduit. Le plasma qui est ainsi généré dans l'enceinte 20 possède la fonction de source des ions qui sont éjectés vers l'extérieur lors du fonctionnement du propulseur 2.

Le propulseur ionique à grilles 2 comprend en outre au moins deux grilles conductrices électriquement, qui sont disposées parallèlement et à distance l'une de l'autre devant l'ouverture de sortie de l'enceinte à plasma 20. La première grille, appelée grille d'écran et désignée par la référence 24 a pour fonctions principales de contrôler la quantité d'ions qui sortent de l'enceinte à plasma 20 et de participer à accélérer ces ions. Pour cela, la grille d'écran 24 est portée à une tension électrique positive qui est notée $V_{PHV}$. La seconde grille, appelée grille d'accélération et désignée par la référence 25, contribue à accélérer les ions qui sortent de l'enceinte à plasma 20, en coopération avec la grille d'écran 24, et crée simultanément une barrière de potentiel électrique entre la grille d'écran 24 et le neutraliseur 27 décrit plus loin, pour des électrons qui sont émis par ce dernier. Pour cela, la grille d'accélération 25 est portée à une tension électrique négative qui est notée $V_{NHV}$. La grille d'écran 24 est intermédiaire entre l'ouverture de sortie de l'enceinte à plasma 20 et la grille d'accélération 25. Possiblement, le propulseur 2 peut comprendre en outre au moins une troisième grille additionnelle. Une telle troisième grille, dite grille de décélération, peut être destinée à être connectée électriquement à une masse électrique du véhicule spatial.

Le propulseur 2 de type GIT comprend en outre les deux composants suivants, qui sont associés à la cathode 22 : une résistance de chauffage de cathode, désignée par la référence 26, et un système de maintien 220 qui est distinct de l'anode 21 dont la fonction est de conduire la décharge électrique de génération du plasma dans l'enceinte 20. Dans [Fig. 1], la notation CATH. désigne l'ensemble de cathode qui est formé par la cathode 22 elle-même, sa résistance de chauffage 26 et son système de maintien 220.

Le neutraliseur 27, noté NEUTR., a pour fonction lors du fonctionnement du propulseur 2, d'émettre vers l'extérieur un faisceau d'électrons pour neutraliser le faisceau des ions qui sortent de l'enceinte à plasma 20 à travers les grilles 24 et 25. Il comprend un émetteur d'électrons 271, un système de maintien de neutraliseur 272 et une résistance de chauffage de neutraliseur 273.

L'ensemble d'alimentation électrique 1 comprend plusieurs unités d'alimentation séparées qui sont dédiées à alimenter respectivement en tensions et courants électriques les composants du propulseur 2. Pour cela, chacune de ces unités d'alimentation possède une première borne de sortie qui est connectée électriquement au composant correspondant, et une seconde borne de sortie qui est connectée à un nœud commun de référence communément désigné par CRP pour «Cathode Return Potential» en anglais, ou parfois NRP pour «Neutralizer Return Potential». Ce nœud commun de référence CRP est lui-même connecté électriquement à une masse électrique 10 de l'ensemble d'alimentation électrique 1 par un système conducteur de charges 17, parfois appelé «bleed resistor» en anglais. L'ensemble d'alimentation électrique 1 comprend notamment les unités d'alimentation suivantes :

- une unité d'alimentation de plasma 11, notée ANODE et dédiée à alimenter l'anode 21 de l'enceinte à plasma 20 en courant électrique, cette unité d'alimentation 11 constituant l'étage d'alimentation de décharge de l'ensemble d'alimentation électrique 1 pour le cas GIT ;

- une unité d'alimentation de confinement magnétique 110, notée MAGNET et dédiée à alimenter électriquement le système de confinement magnétique 23 ;
- une unité d'alimentation 12 qui est dédiée à la polarisation de la grille d'écran 24, et notée PHV pour «positive high voltage» en anglais ;
- une unité d'alimentation 13 qui est dédiée à la polarisation de la grille d'accélération 25, et notée NHV pour «negative high voltage» ;
- un ensemble d'alimentation de neutraliseur 15, qui est dédié à alimenter le système de maintien 272 du neutraliseur 27 en courant électrique. Cet ensemble d'alimentation de neutraliseur 15 peut lui-même comprendre une unité d'alimentation d'allumage du neutraliseur 27, notée NEUTR. IGNITOR, et une unité d'alimentation de maintien du neutraliseur 27, notée NEUTR. KEEPER, qui sont connectées en parallèle ; et
- une unité d'alimentation de chauffage de neutraliseur 16, notée NEUTR. HEATER et dédiée à alimenter électriquement la résistance de chauffage de neutraliseur 273.

Pour le propulseur 2 du type GIT de [Fig. 1], l'ensemble d'alimentation électrique 1 comprend en outre les unités d'alimentation supplémentaires suivantes qui sont dédiées à l'ensemble de cathode :

- un ensemble d'alimentation de cathode 111, qui est dédié à alimenter le système de maintien 220 en courant électrique. Cet ensemble d'alimentation de cathode 111 peut lui-même comprendre une unité d'alimentation d'allumage de la cathode 22, notée CATH. IGNITOR, et une unité d'alimentation de maintien de la cathode 22, notée CATH. KEEPER, qui sont connectées en parallèle ; et
- une unité d'alimentation de chauffage de cathode 112, notée CATH. HEATER et dédiée à alimenter électriquement la résistance de chauffage de cathode 26.

Par ailleurs, l'ensemble d'alimentation électrique 1 comprend en outre un dispositif d'asservissement qui est associé à l'unité d'alimentation de plasma 11, et qui est adapté pour varier en temps réel la puissance de décharge délivrée par celle-ci de façon à maintenir constant un courant de faisceau $I_{beam}$ pendant un fonctionnement nominal du propulseur 2. Ce dispositif d'asservissement, appelé BCC pour «beam current control», peut comprendre un module de mesure 12m qui est agencé pour mesurer le courant $I_{PHV}$ transmis par l'unité d'alimentation 12 à la grille d'écran 24, un module de mesure 13m qui est agencé pour mesurer le courant $I_{NHV}$ reçu par l'unité d'alimentation 13 en provenance de la grille d'accélération 25, et un module 18 qui est adapté pour contrôler la puissance électrique qui est délivrée en sortie par l'unité d'alimentation de plasma 11. Les modules de mesure 12m et 13m transmettent en temps réel au module 18 les valeurs mesurées des courants $I_{PHV}$ et $I_{NHV}$, afin que le module 18 ajuste le courant de décharge $I_d$ pour maintenir constante une valeur de la différence $I_{PHV} - I_{NHV}$. Cette valeur de différence $I_{PHV} - I_{NHV}$ correspond au courant de faisceau $I_{beam}$ pour un fonctionnement nominal du propulseur 2, c'est-à-dire en l'absence de rétro-circulation d'électrons qui proviennent du neutraliseur 27 et qui sont collectés par la grille d'écran 24. Le mode de fonctionnement du propulseur 2 pour lequel la différence $I_{PHV} - I_{NHV}$ est constante, est obtenu en activant le dispositif d'asservissement BCC, et le mode de fonctionnement pour lequel la puissance de décharge est constante, est obtenu en désactivant le dispositif d'asservissement BCC.

Enfin, l'ensemble d'alimentation électrique 1 peut comprendre en outre un variateur 30, noté VAR., qui est agencé pour contrôler la valeur de la tension électrique négative $V_{NHV}$ qui est fournie par l'unité d'alimentation 13. Pour cela, une sortie du variateur 30 est connectée à une entrée de commande de l'unité d'alimentation 13. Le variateur 30 est utile pour ajuster un point un fonctionnement du propulseur 2, et aussi pour appliquer au propulseur 2 un test de rétro-circulation électronique, tel que désigné par test EBS pour «Electron Back-Streaming».

Pour être connecté à l'ensemble d'alimentation électrique 1, le propulseur 2 de type GIT comprend les bornes suivantes, avec leurs liaisons électriques respectives aux composants du propulseur, de façon interne à ce dernier :

- une borne A1, reliée électriquement à la grille d'écran 24 ;
- une borne A2, reliée électriquement à la grille d'accélération 25 ;
- une borne A3, reliée électriquement à l'émetteur d'électrons 271 du neutraliseur 27 ;
- une borne A4, reliée électriquement au système de maintien 272 du neutraliseur 27 ;
- une borne A5, reliée électriquement à une masse électrique du propulseur 2 ;
- deux bornes A6 et A7, reliées électriquement à deux extrémités de la résistance de chauffage de neutraliseur 273 ;
- une borne A8, reliée électriquement au système de maintien 220 qui est associé à la cathode 22 ;
- deux bornes A9 et A10, reliées électriquement à deux extrémités de la résistance de chauffage de cathode 26 ;
- une borne A11, reliée électriquement à la cathode 22 ;
- deux bornes A12 et A13, reliées électriquement à deux extrémités d'une bobine du système de confinement magnétique 23 ; et

- une borne A14, reliée électriquement à l'anode 21 de l'enceinte à plasma 20.

Pour produire le fonctionnement du propulseur 2, l'ensemble d'alimentation électrique 1 est connecté de la façon suivante au propulseur 2 :

- la borne A1 du propulseur 2 est connectée à la borne de sortie positive de l'unité d'alimentation 12, la borne de sortie négative de l'unité d'alimentation 12 étant connectée électriquement au nœud commun de référence CRP de façon interne à l'ensemble d'alimentation électrique 1. De cette façon, l'unité d'alimentation 12 fournit la tension électrique positive $V_{PHV}$ à la grille d'écran 24, avec le courant électrique associé $I_{PHV}$, appelé courant de grille d'écran, la tension $V_{PHV}$ étant définie ainsi par rapport au nœud commun de référence CRP ;
- la borne A2 du propulseur 2 est connectée à la borne de sortie négative de l'unité d'alimentation 13, la borne de sortie positive de l'unité d'alimentation 13 étant connectée électriquement au nœud commun de référence CRP de façon interne à l'ensemble d'alimentation électrique 1. De cette façon, l'unité d'alimentation 13 fournit la tension électrique négative $V_{NHV}$ à la grille d'accélération 25, avec le courant électrique associé $I_{NHV}$, appelé courant de grille d'accélération, la tension $V_{NHV}$ étant aussi définie par rapport au nœud commun de référence CRP ;
- la borne A3 du propulseur 2 est connectée au nœud commun de référence CRP de l'ensemble d'alimentation électrique 1. De cette façon, un courant de retour de neutraliseur $I_{neutr}$ circule de l'émetteur d'électrons 271 au nœud commun de référence CRP lors du fonctionnement du propulseur 2 ;
- la borne A4 du propulseur 2 est connectée à une borne de sortie positive de l'ensemble d'alimentation de neutraliseur 15, la borne de sortie négative de l'ensemble d'alimentation 15 étant connectée électriquement au nœud commun de référence CRP de façon interne à l'ensemble d'alimentation électrique 1. De cette façon, l'ensemble d'alimentation 15 fournit un courant électrique $I_{keeper}$ au système de maintien 272 du neutraliseur 27. Ce courant $I_{keeper}$, appelé courant de maintien de neutraliseur et circulant de l'ensemble d'alimentation électrique 1 vers le système de maintien 272, sert à maintenir une température du neutraliseur 27 ;
- la borne A5 du propulseur 2 est connectée à la masse électrique 10 de l'ensemble d'alimentation électrique 1 ;
- la borne A6 du propulseur 2 est connectée au nœud commun de référence CRP de l'ensemble d'alimentation électrique 1 ;
- la borne A7 du propulseur 2 est connectée à une borne de sortie de l'unité d'alimentation de chauffage de neutraliseur 16, l'autre borne de sortie de cette dernière étant connectée électriquement au nœud commun de référence CRP de façon interne à l'ensemble d'alimentation électrique 1. De cette façon, l'unité d'alimentation 16 fait circuler un courant électrique de chauffage dans la résistance 273 ;
- la borne A8 du propulseur 2 est connectée à une borne de sortie positive de l'ensemble d'alimentation de cathode 111, la borne de sortie négative de l'ensemble d'alimentation 111 étant connectée électriquement au nœud commun de référence CRP de façon interne à l'ensemble 1. De cette façon, l'ensemble d'alimentation 111 fournit un courant électrique $I_{keeper\_cath}$ au système de maintien 220 qui est associé à la cathode 22. Ce courant $I_{keeper\_cath}$, appelé courant de maintien de cathode et circulant de l'ensemble d'alimentation électrique 1 vers le système de maintien de cathode 220, sert à maintenir une température de l'ensemble de cathode ;
- la borne A9 du propulseur 2 est connectée au nœud commun de référence CRP de l'ensemble d'alimentation électrique 1 ;
- la borne A10 du propulseur 2 est connectée à une borne de sortie de l'unité d'alimentation de chauffage de cathode 112, l'autre borne de sortie de cette dernière étant connectée électriquement au nœud commun de référence CRP de façon interne à l'ensemble d'alimentation électrique 1. De cette façon, l'unité d'alimentation 112 fait circuler un autre courant électrique de chauffage dans la résistance 26 ;
- la borne A11 du propulseur 2 est connectée au nœud commun de référence CRP de l'ensemble d'alimentation électrique 1. De cette façon, un courant de retour de cathode $I_{return\_cath}$ circule de la cathode 22 au nœud commun de référence CRP lors du fonctionnement du propulseur 2 ;
- la borne A12 du propulseur 2 est connectée au nœud commun de référence CRP de l'ensemble d'alimentation électrique 1 ;
- la borne A13 du propulseur 2 est connectée à une borne de sortie de l'unité d'alimentation de confinement magnétique 110, l'autre borne de sortie de cette dernière étant connectée électriquement au nœud commun de référence CRP de façon interne à l'ensemble d'alimentation électrique 1 ; et
- la borne A14 du propulseur 2 est connectée à une borne de sortie positive de l'unité d'alimentation de plasma 11, la borne de sortie négative de cette dernière étant connectée électriquement au nœud commun de référence CRP de façon interne à l'ensemble 1. De cette façon, un courant de décharge $I_d$ circule de l'unité d'alimentation 11 à l'anode 21 de l'enceinte à plasma 20 lors du fonctionnement du propulseur 2.

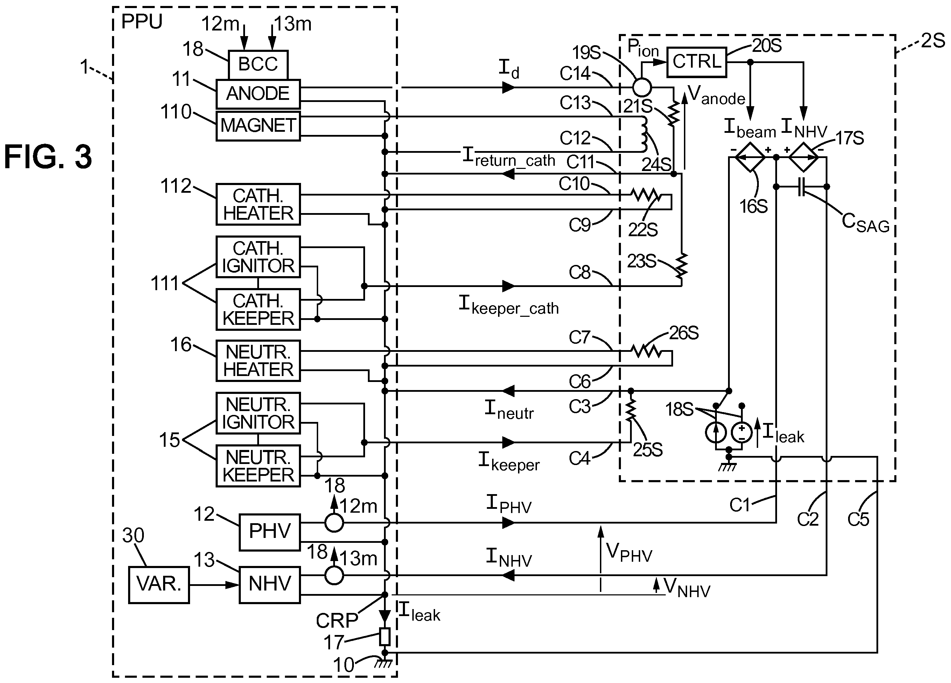

Conformément à [Fig. 3], un dispositif de test S2 est adapté pour être connecté à l'ensemble d'alimentation électrique 1 de [Fig. 1] à la place du propulseur 2 de type GIT. Pour cela, le dispositif de test 2S comprend des bornes C1-C14 qui sont destinées à remplacer respectivement les bornes A1-A14 du propulseur 2 : la borne C1 à la place de la borne A1, la borne C2 à la place de la borne A2, ..., la borne C14 à la place de la borne A14. Dans la partie générale de la présente description, la borne C1 a été appelée première borne, la borne C2 deuxième borne, la borne C3 troisième borne, la borne C4 quatrième borne, la borne C5 borne de masse électrique, et les bornes C8-C14 cinquièmes bornes. Parmi ces dernières, la borne C8 a été appelée borne de simulation de cathode, les bornes C9 et C10 ont été appelées bornes de simulation de chauffage de cathode, la borne C11 a été appelée borne de retour de courant, les bornes C12 et C13 ont été appelées bornes de simulation de confinement magnétique, et la borne C14 a été appelée borne d'alimentation en courant de décharge.

Le dispositif de test 2S comprend alors les composants suivants :

- une première source de courant dépendante 16S, dont la borne positive est connectée à la borne C1 de façon interne au dispositif de test 2S, et la borne négative est connectée à la borne C3 aussi de façon interne au dispositif de test 2S. Cette source de courant dépendante 16S fonctionne en tant que récepteur en constituant une charge qui est commune à l'unité d'alimentation 12, à la source électrique additionnelle 18S décrite plus loin, et à l'ensemble d'alimentation de neutraliseur 15. La source de courant dépendante 16S impose un courant de valeur $I_{beam}$ pour circuler, à l'intérieur de cette source de courant dépendante 16S, de sa borne positive vers sa borne négative ;

- une seconde source de courant dépendante 17S, dont la borne positive est connectée de même à la borne C1 de façon interne au dispositif de test 2S, et la borne négative est connectée à la borne C2 aussi de façon interne au dispositif de test 2S. Cette source de courant dépendante 17S fonctionne aussi en tant que récepteur, mais en constituant une charge qui est commune aux unités d'alimentation 12 et 13. Elle impose un courant de valeur $I_{NHV}$ qui sort du dispositif de test 2S par sa borne C2. Ce courant $I_{NHV}$ circule à l'intérieur de la source de courant dépendante 17S de sa borne positive vers sa borne négative ;

- une source électrique additionnelle 18S qui est connectée entre la masse électrique du dispositif de test 2S et sa borne C3, et qui produit un courant de valeur $I_{leak}$, positive ou négative. La source électrique 18S peut être soit du type source de courant, soit du type source de tension, en fonction de l'utilisation du propulseur 2 à bord du véhicule spatial. Cette alternative pour la source électrique 18S est représentée symboliquement sous la forme d'un interrupteur dans [Fig. 3]. La source électrique 18S est du type source de courant lorsque sa résistance interne est très supérieure à la valeur de résistance du système conducteur de charges 17 de l'ensemble d'alimentation électrique 1, et du type source de tension lorsque sa résistance interne est très inférieure à la valeur de résistance du système conducteur de charges 17 ;

- une résistance 25S, appelée résistance de simulation de maintien de neutraliseur dans la partie générale de la présente description, qui est connectée entre les bornes C3 et C4, pour imiter une résistance de décharge qui existe entre l'émetteur d'électrons 271 et son système de maintien 272 lors du fonctionnement du propulseur 2 ;

- une connexion électrique qui relie la borne C5 à une masse électrique du dispositif de test 2S ;

- une résistance 26S, dite résistance de simulation de chauffage de neutraliseur, qui est connectée entre les bornes C6 et C7, pour imiter la résistance de chauffage de neutraliseur 273 du propulseur 2 ;

- une résistance additionnelle 23S, dite résistance de simulation de maintien de cathode, qui est connectée entre les bornes C8 et C11, pour imiter une résistance de décharge qui existe entre la cathode 22 de l'enceinte à plasma 20 et son système de maintien 220 lors du fonctionnement du propulseur 2 ;

- une autre résistance additionnelle 22S, dite résistance de chauffage de cathode, qui est connectée entre les bornes C9 et C10, pour imiter la résistance de chauffage de cathode 26 du propulseur 2 ;

- une bobine 24S qui est connectée entre les bornes C12 et C13, pour imiter une bobine du système de confinement magnétique 23 du propulseur 2 ;

- une résistance 21S, appelée résistance de simulation de l'enceinte à plasma du propulseur dans la partie générale de la présente description, qui est connectée entre les bornes C11 et C14, pour imiter une résistance de décharge qui existe entre l'anode 21 de l'enceinte à plasma 20 et la cathode 22 lors du fonctionnement du propulseur 2 ;

- une unité de mesure 19S, qui est agencée pour mesurer une puissance électrique qui est dissipée dans la résistance 21S, et qui remplace pour l'ensemble d'alimentation électrique 1, la puissance de décharge qui est délivrée par l'unité d'alimentation 11 à l'enceinte à plasma 20 lors du fonctionnement du propulseur 2, afin de former la source des ions qui sont émis à travers les grilles 24 et 25. Par simplicité, la puissance électrique qui est mesurée par l'unité de mesure 19S est aussi appelée puissance de décharge et notée $P_{ion}$ ; et

- un contrôleur 20S, noté CTRL, qui reçoit en entrée la valeur mesurée pour la puissance de décharge $P_{ion}$, et qui est configurée pour délivrer en sortie une valeur de consigne pour le courant $I_{beam}$ à produire par la source de courant dépendante 16S, et une valeur de consigne pour le courant $I_{NHV}$ à produire par la source de courant dépendante 17S. Pour cela, une première sortie du contrôleur 20S est connectée à une entrée de commande de la source de courant dépendante 16S, pour transmettre à celle-ci la valeur de consigne pour $I_{beam}$, et une seconde sortie du contrôleur 20S est connectée à une entrée de commande de la source de courant dépendante 17S, pour transmettre à cette dernière la valeur de consigne pour $I_{NHV}$. Une sortie additionnelle du contrôleur 20S, non-représentée, permet d'activer et de désactiver la source électrique 18S en même temps que la source de courant dépendante 16S ; et

- un condensateur $C_{SAG}$ qui est connecté entre les bornes positive et négative de la source de courant dépendante 17S.

Dans le cadre de la présente description on entend par source de courant une source électrique dont la résistance interne est suffisamment élevée pour que cette source produise en sortie un courant électrique dont la valeur est déterminée à +/-5% près, de préférence +/-1% près, lors de l'utilisation du dispositif de test. De même, on entend par source de tension une source électrique dont la résistance interne est suffisamment faible pour que cette source produise en sortie une tension électrique dont la valeur est déterminée à +/-5% près, de préférence +/-1% près, lors de l'utilisation du dispositif de test. En outre, on entend par source de courant dépendante une source qui produit un courant dont la valeur d'intensité est déterminée par une consigne qui est reçue sur une entrée de commande de cette source. Autrement dit, l'intensité du courant qui est imposé par une source de courant dépendante varie en temps réel conformément à la consigne qui est appliquée sur l'entrée de commande de cette source.

Le courant $I_{beam}$ qui est imposé par la source de courant dépendante 16S est destiné à reproduire le courant de faisceau qui correspond aux ions éjectés par le propulseur 2 vers l'extérieur lors de son fonctionnement pour produire une poussée. Simultanément, le courant $I_{NHV}$ qui est imposé par la source de courant dépendante 17S est destiné à reproduire le courant de grille d'accélération qui est reçu par l'unité d'alimentation 13 lors du fonctionnement du propulseur 2. Enfin, le courant $I_{leak}$ qui est produit par la source électrique 18S est destiné à reproduire le courant qui circule dans le système de conduction de charges 17 de l'ensemble d'alimentation électrique 1 lors du fonctionnement du propulseur 2. Pour ces raisons et pour raison de clarté, les courants électriques $I_{beam}$, $I_{NHV}$ et $I_{leak}$ qui sont mis en œuvre dans le dispositif de test 2S sont directement appelés courant de faisceau, courant de grille d'accélération et courant de fuite, respectivement, dans la présente description.

On décrit maintenant un dimensionnement et une configuration du dispositif de test 2S qui permettent à ce dispositif de test d'imiter, pour l'ensemble d'alimentation électrique 1, le fonctionnement du propulseur 2 qui a été utilisé en tant qu'exemple par les inventeurs :

- la résistance 25S peut être comprise entre 1 $\Omega$ (ohm) et 6 $\Omega$, notamment sensiblement égale à 3,5 $\Omega$ ;
- la résistance 26S peut être comprise entre 5 $\Omega$ et 20 $\Omega$, notamment en étant sensiblement égale à la résistance de chauffage de neutraliseur 273 du propulseur 2 ;
- la résistance additionnelle 23S peut être comprise entre 1 $\Omega$ et 6 $\Omega$, notamment sensiblement égale à 3,5 $\Omega$ ;
- la résistance additionnelle 22S peut être comprise entre 5 $\Omega$ et 20 $\Omega$, notamment en étant sensiblement égale à la résistance de chauffage de cathode 26 du propulseur 2 ;
- la résistance 21S peut être comprise entre 0,5 $\Omega$ et 0,9 $\Omega$, notamment sensiblement égale à 0,7 $\Omega$ ;
- la valeur d'inductance de la bobine 24S peut être comprise entre 1 mH (millihenry) et 50 mH, notamment en étant sensiblement égale à la valeur d'inductance de la bobine du système de confinement magnétique 23 du propulseur 2 ;
- la valeur de capacité du condensateur $C_{SAG}$ peut être déterminée par calcul, à partir d'une modélisation de la capacité d'interaction qui existe entre la grille d'écran 24 et la grille d'accélération 25 du propulseur 2. Par exemple, elle peut être calculée selon la formule : $C_{SAG} = \varepsilon_0 \cdot A_{plan}/d + \varepsilon_0 \cdot (k_{AG} \cdot A_{frange\_AG})/d + \varepsilon_0 \cdot (k_{SG} \cdot A_{frange\_SG})/d$. Dans cette somme, le premier terme correspond au condensateur plan qui est formé par les surfaces respectives de la grille d'écran 24 et de la grille d'accélération 25 qui sont en regard. $A_{plan}$ est alors l'aire de la surface de la grille d'écran 24 en dehors de ses trous, dans un plan qui est parallèle à la grille d'accélération 25, les deux grilles étant supposées avoir des trous qui sont un-à-un en vis-à-vis d'une grille à l'autre, d est la distance de séparation entre les deux grilles, et $\varepsilon_0$ est la permittivité du vide. Le deuxième terme est la capacité de frange de la grille d'accélération 25 par rapport à la grille d'écran 24, où $k_{AG}$ est un coefficient qui peut être pris sensiblement égal à 0,7 et $A_{frange\_AG} = N_{trous} \cdot e_{AG} \cdot \pi \cdot d_{trou\_AG}$, $N_{trous}$ désignant le nombre de trous de chacune des deux grilles, $e_{AG}$ désignant l'épaisseur la grille d'accélération 25 et $d_{trou\_AG}$ désignant le diamètre de chaque trou, supposé circulaire, de la grille d'accélération 25. De façon similaire, le troisième terme est la capacité de frange de la grille d'écran 24 par rapport à la grille d'accélération 25, où $k_{SG}$ est un autre coefficient qui peut aussi être pris sensiblement égal à 0,7 et $A_{frange\_SG} = N_{trous} \cdot e_{SG} \cdot \pi \cdot d_{trou\_SG}$, $e_{SG}$ désignant l'épaisseur la grille d'écran 24 et $d_{trout\_SG}$ désignant le diamètre de chaque trou, encore supposé circulaire, de la grille d'écran 24. Par exemple, la valeur de capacité du condensateur $C_{SAG}$ qui est calculée ainsi peut être sensiblement égale à 1100 pF (picofarad), lorsque la grille d'écran 24 et la grille d'accélération 25 du propulseur 2 ont les caractéristiques suivantes : diamètre de chacune des deux grilles qui est sensiblement égal à 27 cm (centimètre), distance d de séparation entre les deux grilles qui est sensiblement égale à 0,6 mm (millimètre), nombre $N_{trous}$ de trous par grille qui est sensiblement égal à 12000, épaisseur $e_{AG}$ de la grille d'accélération 25 qui est sensiblement égale à 1 mm, diamètre $d_{trou\_AG}$ de chaque trou de la grille d'accélération 25 qui est sensiblement égal à 1,5 mm (millimètre), épaisseur $e_{SG}$ de la grille d'écran 24 qui est sensiblement égale à 0,25 mm, et diamètre $d_{trou\_SG}$ de chaque trou de la grille d'écran 24 qui est sensiblement égal à 1,9 mm (millimètre) ;
- l'unité de mesure 19S peut être configurée pour mesurer le courant de décharge $I_d$ qui rentre dans le dispositif de test 2S par sa borne C14, et pour mesurer la tension électrique $V_{anode}$ de cette borne C14 par rapport à la borne C11, appelée tension de décharge, puis pour calculer la puissance de décharge $P_{ion}$ comme le produit du courant de décharge par la tension de décharge, avec un facteur de correction : $P_{ion} = K_{correction} \cdot V_{anode} \cdot I_d$. $K_{correction}$ est le facteur de correction. Il est saisi dans l'unité de mesure 19S et destiné à compenser un écart possible entre la puissance électrique qui est dissipée dans la résistance 21S du dispositif de test 2S et la puissance de décharge qui est dissipée dans l'enceinte à plasma 20 du propulseur 2 de type GIT. En l'absence d'écart, le paramètre $K_{correction}$ est égal à l'unité, mais il est en général compris entre 0,5 et 2 ;

- le contrôleur 20S peut être configuré pour calculer la valeur du courant de faisceau $I_{beam}$ à partir de chaque résultat de mesure de la puissance de décharge selon la première fonction de transfert suivante : $I_{beam} = K_{beam} \cdot P_{ion}$ si la tension électrique positive $V_{PHV}$ qui est reçue par le dispositif de test 2 sur sa borne C1 est supérieure à un seuil d'extraction d'ions $V_{PHVextr}$, et $I_{beam} = 0$ A si la tension électrique positive $V_{PHV}$ est inférieure ou égale au seuil d'extraction d'ions $V_{PHVextr}$. Par exemple, le seuil d'extraction d'ions $V_{PHVextr}$ peut être compris entre 0 V (volt) et 2000 V, notamment égal à 800 V. Pour obtenir une meilleure imitation du comportement électrique du propulseur 2 par le dispositif de test 2S, le coefficient $K_{beam}$ peut être calculé par le contrôleur 20S en fonction de la tension électrique négative $V_{NHV}$ qui est reçue par le dispositif de test 2S sur sa borne C2, selon la formule : $K_{beam} = K_{beam0} \cdot \{1 + [\exp(V_{NHV} - V_{NHVchange})]/100\}$ si ce coefficient $K_{beam}$ est inférieur à une valeur maximale de coefficient $K_{beammax}$, et $K_{beam} = K_{beammax}$ sinon. Dans la formule précédente, les valeurs de la tension électrique négative $V_{NHV}$ et du paramètre de configuration $V_{NHVchange}$ sont exprimées en volts. $K_{beam0}$ et $K_{beammax}$ sont deux autres paramètres de configuration du dispositif de test 2S. Par exemple, le paramètre de configuration $V_{NHVchange}$ peut être compris entre -300 V et -50 V, notamment égal à -200 V, le paramètre de configuration $K_{beam0}$ peut être compris entre $1,0 \cdot 10^{-3}$ A/W (ampère par watt) et $1,0 \cdot 10^{-2}$ A/W, notamment égal à $3,7 \cdot 10^{-3}$ A/W, et le paramètre de configuration $K_{beammax}$ peut être compris entre 0,10 A/W et 2,0 A/W, notamment égal à 0,50 A/W. Simultanément, le contrôleur 20S peut être configuré pour calculer la valeur du courant de grille d'accélération $I_{NHV}$ à partir de chaque valeur calculée pour le courant de faisceau $I_{beam}$ selon la seconde fonction de transfert suivante : $I_{NHV} = I_{beam}/\beta$, où $\beta$ est un autre paramètre de configuration du dispositif de test 2S. Par exemple, le paramètre de configuration $\beta$ peut être compris entre 10 et 200, notamment égal à 50. Les valeurs qui sont saisies dans le contrôleur 20S pour tous les paramètres de configuration du dispositif de test 2S qui viennent d'être cités peuvent avantageusement être sélectionnées afin que ce dispositif de test 2S imite fidèlement le comportement électrique du propulseur 2 vis-à-vis de l'ensemble d'alimentation électrique 1 ; et

- la valeur du courant qui est produit par la source électrique 18S peut être comprise entre 100 μA (microampère) et 500 mA (milliampère), notamment sensiblement égale à 70 mA, dans les deux cas de fonctionnement en source de courant et en source de tension.

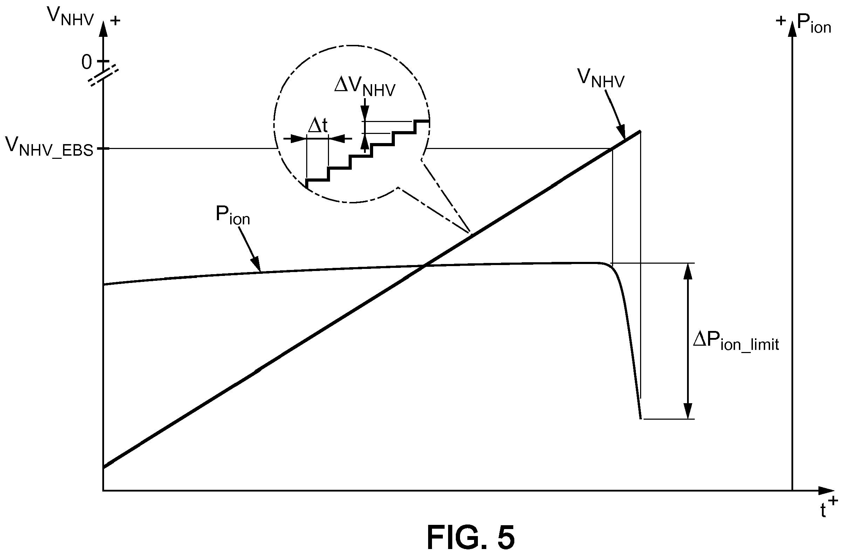

Avec ce dimensionnement et cette configuration, le dispositif de test 2S de [Fig. 3] imite le fonctionnement du propulseur 2 de type GIT de [Fig. 1], lorsqu'il est connecté à l'ensemble d'alimentation électrique 1 à la place de ce propulseur 2. Cette imitation permet alors de tester la capacité de l'ensemble d'alimentation électrique 1 à mettre en œuvre un test EBS comme cela sera décrit plus loin en référence à [Fig. 5].

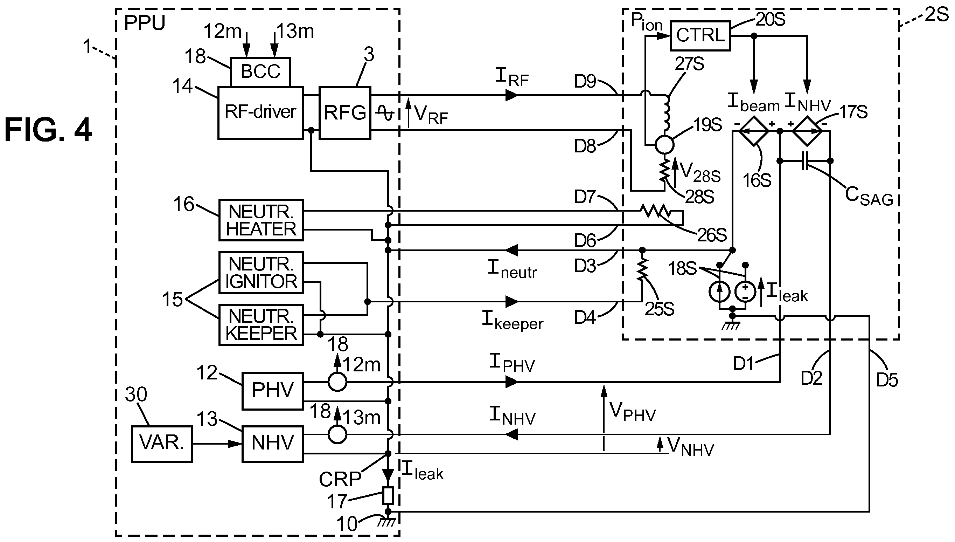

L'application de l'invention à un dispositif de test qui est destiné à imiter le fonctionnement d'un propulseur ionique à grilles à décharge radiofréquence est décrite maintenant. Un tel propulseur, tel que représenté dans [Fig. 2], est désigné par l'acronyme RIT pour «Radiofrequency Ion Thruster». Dans la suite, seules les différences entre le propulseur 2 de type RIT de [Fig. 2] et celui de type GIT de [Fig. 1] sont décrites, de même que seules sont décrites les différences entre le dispositif de test 2S de [Fig. 4] pour le propulseur de type RIT et celui de [Fig. 3] pour le propulseur de type GIT.

Le propulseur 2 de type RIT de [Fig. 2] comprend encore une enceinte à plasma 20, mais celle-ci est munie d'une bobine d'excitation 29 qui est disposée pour générer un champ électromagnétique radiofréquence à l'intérieur de l'enceinte à plasma 20. Le champ électromagnétique radiofréquence produit l'ionisation du gaz qui est introduit dans l'enceinte à plasma 20, et qui constitue ainsi la source d'ions. Pour cela, le propulseur 2 de type RIT comprend deux bornes d'alimentation en radiofréquence B8 et B9 qui sont connectées, à l'intérieur du propulseur 2, à deux extrémités de la bobine d'excitation 29 pour amener dans cette dernière un courant radiofréquence $I_{RF}$ qui constitue le courant de décharge dans le cas RIT. La tension électrique $V_{RF}$ qui existe alors entre les bornes B8 et B9 constitue la tension de décharge pour le cas RIT. Le propulseur 2 de type RIT est dépourvu de cathode.

L'ensemble d'alimentation électrique 1, lorsqu'il est destiné à alimenter le propulseur 2 de type RIT, comprend un générateur 3, noté RFG pour «radiofrequency generator», qui délivre en sortie le courant de décharge $I_{RF}$ et la tension de décharge $V_{RF}$. Ce générateur RFG 3 constitue alors l'étage d'alimentation de décharge de l'ensemble d'alimentation électrique 1 pour le cas RIT. Il est lui-même alimenté par une unité d'alimentation dédiée de l'ensemble d'alimentation électrique 1, désignée par la référence 14 et appelée pilote d'étage d'ionisation RF, ou «RF ionization stage driver» en anglais. Cette unité d'alimentation 14 est notée RF-driver dans [Fig. 2] et remplace l'unité d'alimentation de plasma 11 de [Fig. 1] dans l'ensemble d'alimentation électrique 1. Une des deux bornes de sortie du générateur RFG 3 est connectée au nœud commun de référence CRP, de façon interne à l'ensemble d'alimentation électrique 1. La puissance de décharge $P_{ion}$ qui génère le plasma dans l'enceinte à plasma 20 afin de former la source d'ions, peut être calculée dans un tel cas RIT à partir des valeurs respectives du courant de décharge $I_{RF}$ et de la tension de décharge $V_{RF}$ du générateur RFG 3. Dans le cas RIT, l'ensemble d'alimentation électrique 1 est dépourvu d'ensemble d'alimentation de cathode 111 et d'unité d'alimentation de chauffage de cathode 112.

Pour le cas RIT de [Fig. 2], le dispositif d'asservissement BCC comprend encore le module 18, mais agencé pour contrôler la puissance électrique qui est fournie par l'unité d'alimentation 14 au générateur RFG 3, et dont dépend la puissance électrique qui est délivrée par ce dernier à la bobine d'excitation 29, et qui constitue la puissance de décharge $P_{ion}$. Les modules de mesure de courants 12m et 13m sont agencés pour le cas RIT comme pour le cas GIT, respectivement au niveau des sorties des unités d'alimentation 12 et 13. Lorsque le dispositif d'asservissement BCC est activé, pour le cas RIT, la puissance électrique qui est fournie par l'unité d'alimentation 14 au générateur RFG 3 est ajustée en temps réel pour maintenir constante la différence $I_{PHV}$ - $I_{NHV}$. Encore dans le cas RIT, lorsque le dispositif d'asservissement BCC est désactivé, la bobine d'excitation 29 est alimentée à partir de l'unité d'alimentation 14, par l'intermédiaire du générateur RFG 3, avec la puissance de décharge $P_{ion}$ qui est maintenue constante.

Pour imiter le fonctionnement électrique du propulseur 2 de type RIT, le dispositif de test 2S de [Fig. 4] comprend une bobine 27S et une résistance 28S de simulation d'enceinte à plasma qui sont connectées en série entre deux bornes D8 et D9 du dispositif de test 2S. Ces deux bornes D8 et D9 ont été appelées bornes d'alimentation en radiofréquence du dispositif de test 2S dans la partie générale de la description, et constituent les cinquièmes bornes pour le cas RIT. Les bornes D1-D7 du dispositif de test de propulseur de type RIT ([Fig. 4]) correspondent respectivement aux bornes C1-C7 du dispositif de test de propulseur de type GIT ([Fig. 3]), en ayant des fonctions qui sont identiques à celles de ces dernières : la borne D1 remplace la borne C1, la borne D2 remplace la borne C2, ..., la borne D7 remplace la borne C7.

Pour le dimensionnement du dispositif de test 2S de [Fig. 4] (cas RIT), la résistance 28S peut être comprise entre 4 $\Omega$ et 7 $\Omega$, notamment sensiblement égale à 5,5 $\Omega$, et la valeur d'inductance de la bobine 27S peut être comprise entre 4 $\mu$H (microhenry) et 15 $\mu$H, notamment en étant sensiblement égale à la valeur d'inductance de la bobine d'excitation 29 du propulseur 2 de [Fig. 2].

A l'intérieur du dispositif de test 2S dans le cas RIT, l'unité de mesure 19S détermine la puissance de décharge $P_{ion}$ à partir de valeurs mesurées pour le courant radiofréquence $I_{RF}$ qui circule dans la résistance 28S et pour une tension $V_{28S}$ qui existe entre les extrémités de cette résistance 28S. L'unité de mesure 19S peut alors calculer la puissance de décharge $P_{ion}$ selon la formule suivante : $P_{ion} = K_{correction} \cdot V_{28S} \cdot conj(I_{RF}) /2$, où conj(y) désigne un nombre complexe qui est conjugué de y, et $K_{correction}$ est encore un facteur de correction qui est saisi dans l'unité de mesure 19S. Pour le cas RIT, le facteur de correction $K_{correction}$ est destiné à compenser un écart possible entre la puissance électrique qui est dissipée dans la bobine 27S et la résistance 28S du dispositif de test 2S, et la puissance de décharge qui est dissipée dans la bobine d'excitation 29 du propulseur 2 de type RIT.

Le contrôleur 20S du dispositif de test 2S dans le cas RIT peut être configuré d'une façon qui est similaire à celle qui a été décrite pour le cas GIT.

Pour simuler le fonctionnement du propulseur 2 de type RIT, le dispositif de test 2S de [Fig. 4] est connecté à l'ensemble d'alimentation électrique 1 de la façon suivante :

- la borne D9 est connectée à l'une des deux bornes de sortie du générateur RFG 3, c'est-à-dire celle qui n'est pas connectée au nœud commun de référence CRP à l'intérieur de l'ensemble d'alimentation électrique 1 ;
- la borne D8 est connectée au nœud commun de référence CRP de l'ensemble d'alimentation électrique 1 ; et
- les bornes D1-D7 sont connectées à l'ensemble d'alimentation électrique 1 de la même façon que les bornes C1-C7 du cas GIT : la borne D1 est connectée comme la borne C1, la borne D2 est connectée comme la borne C2, ..., la borne D7 est connectée comme la borne C7.

Tous les autres composants du dispositif de test 2S dans le cas RIT sont similaires, et ont des configurations similaires, ainsi que des connexions similaires, aux composants correspondants du cas GIT.

Le dispositif de test 2S, pour les deux cas GIT et RIT, est utile pour tester le bon fonctionnement de l'ensemble d'alimentation électrique 1 avant que le véhicule spatial dans lequel cet ensemble est destiné à être intégré, soit lancé dans l'espace extraterrestre. Ce test peut être effectué sur l'ensemble d'alimentation électrique 1 avant et/ou après que celui-ci a été intégré dans le véhicule spatial. Dans chaque cas, il peut être effectué alors que l'ensemble d'alimentation électrique 1 est soumis à des conditions ambiantes, c'est-à-dire à une température d'environ 25°C (degré Celsius) et une pression d'environ 1 bar, ou à des conditions de température et pression réduites qui reproduisent approximativement des conditions extraterrestres. Cela permet de tester l'ensemble d'alimentation électrique, ainsi qu'un harnais de connexion qui est utilisé pour connecter cet ensemble au propulseur, séparément du propulseur ionique à grilles, et dans des conditions opératoires simplifiées.

De façon générale, le courant électrique qui correspond au faisceau des ions qui sont émis par le propulseur 2 vers l'extérieur, c'est-à-dire le courant de faisceau, est dans les deux cas GIT et RIT : $I_{beam} = I_{PHV} - I_{NHV} - I_{PHV\_EBS}$. Dans ce bilan de courants électriques, $I_{PHV\_EBS}$ est un courant supplémentaire qui est fourni par l'unité d'alimentation 12 à la grille d'écran 14, mais qui ne participe pas à la poussée produite parce qu'il est consommé par la rétro-circulation d'électrons à partir du neutraliseur 27 jusqu'à la grille d'écran 14. Pour un fonctionnement nominal du propulseur, le courant de rétro-circulation électronique $I_{PHV\_EBS}$ est très faible et négligeable, de sorte qu'alors le courant de faisceau est sensiblement égal à la différence entre le courant de grille d'écran et le courant de grille d'accélération : $I_{beam} \approx I_{PHV} - I_{NHV}$. Néanmoins, il est important de connaître à des instants qui sont répartis dans la durée d'utilisation du propulseur, une limite relative à la tension électrique négative $V_{NHV}$ à partir de laquelle la rétro-circulation électronique devient importante. La connaissance de cette limite est utile notamment pour ajuster un point de fonctionnement du propulseur qui en soit suffisamment éloigné. Cette limite est déterminée en effectuant un test EBS, qui est contrôlé par l'ensemble d'alimentation électrique et appliqué au propulseur. Un tel test EBS consiste à augmenter progressivement la tension électrique négative $V_{NHV}$, en maintenant constante la tension électrique positive $V_{PHV}$, et alors que le dispositif d'asservissement BCC est maintenu activé. La tension électrique négative $V_{NHV}$ est variée par le variateur 30 qui contrôle l'unité d'alimentation 13. Du fait de la boucle de rétroaction BCC, la puissance de décharge $P_{ion}$ qui est délivrée par l'unité d'alimentation 11 ou par le générateur RFG 3, respectivement selon le cas GIT ou RIT, décroît fortement lorsque la rétro-circulation électronique commence à se produire puisque le courant de sortie des ions est alors remplacé progressivement par le courant de rétro-circulation électronique.

Le dispositif de test 2S de l'invention, pour le cas GIT comme pour le cas RIT, permet de vérifier sur Terre si l'ensemble d'alimentation électrique 1 est capable de contrôler un test EBS. Une telle vérification peut être effectuée avant ou après que l'ensemble d'alimentation électrique 1 a été intégré dans le véhicule spatial, et dans des conditions ambiantes sur Terre ou dans des conditions qui reproduisent celles extraterrestres. Pour cela, l'ensemble d'alimentation électrique 1 est connecté au dispositif de test 2S comme cela a été décrit en relation avec [Fig. 3] ou [Fig. 4], et une exécution de test EBS est déclenchée par l'ensemble d'alimentation électrique 1. Le déroulement du test est alors contrôlé automatiquement par l'ensemble d'alimentation électrique 1 : la puissance de décharge $P_{ion}$ est mesurée pour chaque valeur de la tension électrique négative $V_{NHV}$ qui est commandée par le variateur 30 et produite par l'unité d'alimentation 13. Cette mesure de $P_{ion}$ peut être réalisée au sein de l'unité d'alimentation 11 pour le cas GIT, ou au sein du générateur RFG 3 pour le cas RIT. Le diagramme de [Fig. 5] montre le principe du déroulement du test EBS. Dans ce diagramme, l'axe horizontal repère le temps, noté t, l'axe vertical de gauche repère les valeurs de la tension électrique négative $V_{NHV}$ qui sont commandées successivement, et l'axe vertical de droite repère les valeurs de la puissance de décharge $P_{ion}$ qui sont mesurées pour les valeurs commandées de la tension $V_{NHV}$. Au cours du test EBS, la tension électrique négative $V_{NHV}$ est progressivement augmentée, à partir de valeurs très négatives vers des valeurs de moins en moins négatives. Cette augmentation de la tension $V_{NHV}$ est réalisée par marches ascendantes successives, avec un incrément $\Delta V_{NHV}$ et une durée individuelle de marche $\Delta t$ qui sont sélectionnés pour établir un compromis entre la durée du test et sa précision. Pour chaque valeur de la tension électrique négative $V_{NHV}$ qui est produite ainsi, la valeur de la puissance de décharge $P_{ion}$ est mesurée et enregistrée. Lors du test, la puissance de décharge $P_{ion}$ augmente d'abord faiblement, puis décroît brutalement lorsque la rétro-circulation électronique commence à apparaître. La valeur de la tension électrique négative pour laquelle débute la rétro-circulation électronique, notée $V_{NHV\_EBS}$ et appelée valeur de seuil, constitue le résultat du test. Elle correspond à la position d'un coude dans la courbe des valeurs mesurées pour la puissance de décharge $P_{ion}$ en fonction du temps t, ou en fonction des valeurs de la tension électrique négative $V_{NHV}$. Le balayage croissant des valeurs de la tension électrique négative $V_{NHV}$ peut être arrêté lorsque la puissance de décharge $P_{ion}$ a chuté d'un écart prédéterminé, noté $\Delta P_{ion\_limit}$ et appelé valeur limite de réduction. Par exemple, cette valeur limite de réduction $\Delta P_{ion\_limit}$ peut être fixée égale à 40 W (watt). La variation de la puissance de décharge qui est comparée à la valeur limite de réduction $\Delta P_{ion\_limit}$ peut être calculée par rapport à une valeur maximale qui a été atteinte par la puissance de décharge $P_{ion}$ lors du balayage des valeurs de la tension électrique négative $V_{NHV}$. Alternativement, la valeur limite de réduction $\Delta P_{ion\_limit}$ peut être fixée pour correspondre à une réduction prédéterminée, par exemple de 5%, de la puissance de décharge $P_{ion}$ par rapport à sa valeur initiale au début du test, c'est-à-dire par rapport à la valeur de $P_{ion}$ qui a été mesurée pour la valeur de la tension électrique $V_{NHV}$ la plus négative. Lorsque le test EBS est effectué avec le dispositif de test 2S configuré comme décrit plus haut, la valeur de seuil $V_{NHV\_EBS}$ telle que déterminée par le test devrait coïncider avec celle du paramètre de configuration $V_{NHVchange}$ qui a été saisie dans le dispositif de test 2S. La concordance entre les deux valeurs $V_{NHV\_EBS}$ et $V_{NHVchange}$ valide le fonctionnement de l'ensemble d'alimentation électrique 1 pour la réalisation du test. Par exemple, ce fonctionnement peut être déclaré correct si $|V_{NHV\_EBS} - V_{NHVchange}|/|V_{NHVchange}| < 1\%$, sinon un dysfonctionnement est déclaré pour l'ensemble d'alimentation électrique 1.

Il est entendu que l'invention peut être reproduite en modifiant des aspects secondaires des modes de réalisation qui ont été décrits en détail ci-dessus, tout en conservant certains au moins des avantages cités. Notamment, toutes les valeurs numériques qui ont été citées ne l'ont été qu'à titre d'illustration, et peuvent varier en fonction du modèle de propulseur ionique à grilles qui est considéré.

## Revendications

1. Dispositif électrique (2S) destiné à se comporter comme un propulseur ionique à grilles (2) lorsque le dispositif est connecté électriquement, par des bornes dudit dispositif, à un ensemble d'alimentation électrique (1) de pilotage du propulseur, le dispositif comprenant au moins :

- une première borne (C1 ; D1) pour recevoir une tension électrique positive ($V_{PHV}$) fournie par l'ensemble d'alimentation électrique (1), et destinée à remplacer une borne d'alimentation (A1 ; B1) d'une grille d'écran (24) du propulseur (2) ;
- une deuxième borne (C2 ; D2) pour recevoir une tension électrique négative ($V_{NHV}$) fournie par l'ensemble d'alimentation électrique (1), et destinée à remplacer une borne d'alimentation (A2 ; B2) d'une grille d'accélération (25) du propulseur (2) ;
- une troisième borne (C3 ; D3) pour transmettre à un nœud commun de référence (CRP) de l'ensemble d'alimentation électrique (1), un courant de retour ($I_{neutr}$) provenant du dispositif (2S), et destinée à remplacer une borne de retour de courant (A3 ; B3) d'un neutraliseur (27) du propulseur (2) ayant pour fonction de générer un flux d'électrons de neutralisation de faisceau ionique lors d'un fonctionnement du propulseur, le nœud commun de référence formant une référence de potentiel électrique pour la tension électrique positive ($V_{PHV}$) et pour la tension électrique négative ($V_{NHV}$) ;
- une quatrième borne (C4 ; D4) pour recevoir un courant de maintien de neutraliseur ($I_{keeper}$) provenant de l'ensemble d'alimentation électrique (1), et destinée à remplacer une borne (A4 ; B4) d'un système de maintien (272) du neutraliseur (27) du propulseur (2) ayant pour fonction de maintenir une température dudit neutraliseur lors du fonctionnement du propulseur ;
- une résistance de simulation de maintien de neutraliseur (25S), qui est connectée entre les troisième (C3 ; D3) et quatrième (C4 ; D4) bornes du dispositif (2S) ;
- au moins deux cinquièmes bornes (C8-C14 ; D8, D9) pour recevoir une puissance de décharge ($P_{ion}$) qui est fournie par un étage d'alimentation de décharge (11 ; 3) de l'ensemble d'alimentation électrique (1), et destinées à remplacer au moins en partie des bornes (A8-A14 ; B8, B9) du propulseur (2) qui sont dédiées à recevoir la puissance de décharge pour générer un plasma ayant une fonction de source d'ions lors du fonctionnement du propulseur ;

le dispositif étant **caractérisé en ce qu'**il comprend en outre :

- une unité de mesure (19S), agencée pour mesurer la puissance de décharge ($P_{ion}$) reçue ;
- une première source de courant dépendante (16S), qui possède une borne positive connectée à la première borne (C1 ; D1) du dispositif (2S) et une borne négative connectée à la troisième borne (C3 ; D3) dudit dispositif, la première source de courant dépendante étant destinée à fixer un courant de faisceau (**$I_{beam}$**) qui s'écoule à travers ladite première source de courant dépendante de la borne positive de ladite première source de courant dépendante vers la borne négative de ladite première source de courant dépendante ;
- une seconde source de courant dépendante (17S), qui possède une borne positive connectée à la première borne (C1 ; D1) du dispositif (2S) et une borne négative connectée à la deuxième borne (C2 ; D2) dudit dispositif, la seconde source de courant dépendante étant destinée à fixer un courant de grille d'accélération ($I_{NHV}$) qui s'écoule à travers ladite seconde source de courant dépendante de la borne positive de ladite seconde source de courant dépendante vers la borne négative de ladite seconde source de courant dépendante ; et
- un condensateur ($C_{SAG}$), qui est connecté entre les bornes positive et négative de la seconde source de courant dépendante (17S),

le dispositif (2S) étant configuré pour déterminer, lorsque le dispositif est alimenté électriquement et connecté à l'ensemble d'alimentation électrique (1), le courant de faisceau (**$I_{beam}$**) en fonction de la puissance de décharge ($P_{ion}$) mesurée par l'unité de mesure (19S) et en fonction d'au moins un paramètre de configuration du dispositif, et pour déterminer en outre le courant de grille d'accélération ($I_{NHV}$) en fonction du courant de faisceau (**$I_{beam}$**) et en fonction d'au moins un autre paramètre de configuration du dispositif.

2. Dispositif (2S) selon la revendication 1, dans lequel le condensateur ($C_{SAG}$) qui est connecté entre les bornes positive et négative de la seconde source de courant dépendante (17S), est destiné à simuler une capacité d'interaction qui existe entre la grille d'écran (24) et la grille d'accélération (25) du propulseur (2), et ledit condensateur ($C_{SAG}$) possède une valeur de capacité déterminée en additionnant les trois contributions suivantes :

- une première contribution qui correspond à des faces respectives de la grille d'écran (24) et la grille d'accélération (25) du propulseur (2) qui sont en vis-à-vis ;
- une deuxième contribution qui correspond à une capacité de frange de la grille d'écran (24) du propulseur (2), existant entre la grille d'accélération (25) et des surfaces latérales de trous de ladite grille d'écran ; et
- une troisième contribution qui correspond à une capacité de frange de la grille d'accélération (25) du propulseur (2), existant entre la grille d'écran (24) et des surfaces latérales de trous de ladite grille d'accélération.

3. Dispositif (2S) selon la revendication 1 ou 2, comprenant en outre :

- une borne de masse électrique (C5 ; D5), qui est destinée à être connectée à une masse électrique (10) de l'ensemble d'alimentation électrique (1) à la place d'une borne de masse électrique (A5 ; B5) du propulseur (2) ; et
- une source électrique additionnelle (18S), qui possède une première borne connectée à la troisième borne (C3 ; D3) du dispositif (2S), et une seconde borne connectée à la borne de masse électrique (C5 ; D5) dudit dispositif, pour produire pendant un fonctionnement du dispositif, un courant électrique destiné à imiter un courant de fuite ($I_{leak}$) qui se produit dans le propulseur (2) lors du fonctionnement dudit propulseur, le dispositif étant configuré pour activer ou désactiver la source électrique additionnelle conformément à un état d'activation ou de désactivation, respectivement, de la première source de courant dépendante (16S).

4. Dispositif (2S) selon l'une quelconque des revendication précédentes, comprenant en outre un contrôleur (20S) des première et seconde sources de courant dépendantes, le contrôleur étant configuré de sorte que la première source de courant dépendante (16S) fixe le courant de faisceau **($I_{beam}$)** conformément à la première fonction de transfert suivante : $I_{beam} = K_{beam} \cdot P_{ion}$ si la tension électrique positive ($V_{PHV}$) qui est reçue sur la première borne (C1 ; D1) du dispositif est supérieure à un seuil d'extraction d'ions $V_{PHVextr}$, et $I_{beam} = 0$ A sinon, où $I_{beam}$ désigne le courant de faisceau fixé par ladite première source de courant dépendante, $P_{ion}$ désigne la puissance de décharge reçue par les cinquièmes bornes (C8-C14 ; D8, D9) du dispositif et mesurée par l'unité de mesure (19S), le seuil d'extraction d'ions $V_{PHVextr}$ étant un premier paramètre de configuration du dispositif, et $K_{beam}$ étant un coefficient,
et le contrôleur (20S) étant aussi configuré de sorte que la seconde source de courant dépendante (17S) fixe le courant de grille d'accélération ($I_{NHV}$) conformément à la seconde fonction de transfert suivante : $I_{NHV} = I_{beam}/\beta$, où $I_{NHV}$ désigne le courant de grille d'accélération fixé par ladite seconde source de courant dépendante et $\beta$ est un autre coefficient qui constitue un deuxième paramètre de configuration du dispositif.

5. Dispositif (2S) selon la revendication 4, dans lequel le contrôleur (20S) des première et seconde sources de courant dépendantes est configuré en outre pour déterminer le coefficient $K_{beam}$ selon la formule suivante : $K_{beam} = K_{beam0} \cdot \{1 +[exp(V_{NHV} - V_{NHVchange})]/100\}$ si ledit coefficient $K_{beam}$ est inférieur à une valeur maximale de coefficient $K_{beammax}$, et $K_{beam} = K_{beammax}$ sinon, où exp[ ] désigne une fonction exponentielle, $V_{NHV}$ est la tension électrique négative qui est reçue sur la deuxième borne (C2 ; D2) du dispositif, exprimée en volts, et la valeur maximale de coefficient $K_{beammax}$, ainsi que $K_{beam0}$ et $V_{NHVchange}$ exprimé en volts sont des paramètres supplémentaires de configuration du dispositif.

6. Dispositif (2S) selon l'une quelconque des revendications 1 à 5, dans lequel les cinquièmes bornes (C8-C14) comprennent au moins :

- une borne d'alimentation en courant de décharge (C14), destinée à remplacer une borne (A14) d'anode (21) d'une enceinte à plasma (20) du propulseur (2) où est généré le plasma ayant la fonction de source d'ions lors du fonctionnement du propulseur ; et
- une borne de retour de courant (C11), destinée à remplacer une borne (A11) du propulseur (2) qui transmet à l'ensemble d'alimentation électrique (1) un courant de retour de cathode ($I_{return\_cath}$) provenant d'une cathode (22) de l'enceinte à plasma (20) du propulseur,
le dispositif (2S) comprenant en outre :

- une résistance de simulation de l'enceinte à plasma du propulseur (21S), qui est connectée entre la borne d'alimentation en courant de décharge (C14) et la borne de retour de courant (C11),

et l'unité de mesure (19S) étant adaptée pour mesurer un courant de décharge ($I_d$) qui est reçu par le dispositif (2S) par la borne d'alimentation en courant de décharge (C14), et pour mesurer une tension ($V_{anode}$) qui existe entre des extrémités de la résistance de simulation de l'enceinte à plasma du propulseur (21S), et pour calculer une valeur de la puissance de décharge ($P_{ion}$) reçue à partir de valeurs mesurées respectivement pour le courant de décharge et pour la tension qui existe entre les extrémités de la résistance de simulation de l'enceinte à plasma du propulseur.

7. Dispositif (2S) selon la revendication 6, dans lequel les cinquièmes bornes (C8-C14) comprennent en outre :

- deux bornes de simulation de chauffage de cathode (C9, C10), reliées entre elles par une première résistance additionnelle (22S) à l'intérieur du dispositif (2S), et destinées à remplacer deux bornes (A9, A10) du propulseur (2) qui sont dédiées à alimenter lors du fonctionnement du propulseur, une résistance de chauffage (26) de la cathode (22) de l'enceinte à plasma (20) dudit propulseur ayant la fonction de source d'ions ;

- une borne de simulation cathode (C8), reliée à la borne de retour de courant (C11) par une seconde résistance additionnelle (23S) à l'intérieur du dispositif (2S), et destiné à remplacer une borne (A8) du propulseur (2) qui est dédiée à alimenter avec un courant de maintien de cathode ($I_{keeper\_cath}$) lors du fonctionnement dudit propulseur, un système de maintien (220) associé à la cathode (22) de l'enceinte à plasma (20) du propulseur, supplémentaire par rapport à l'anode (21) de ladite enceinte à plasma et ayant pour fonction de maintenir une température de la cathode pendant le fonctionnement du propulseur ; et

- deux bornes de simulation de confinement magnétique (C12, C13), reliées entre elles à l'intérieur du dispositif (2S) par une bobine (24S) qui est associée à un élément ferromagnétique, et destinées à remplacer deux bornes (A12, A13) du propulseur (2) qui sont dédiées à alimenter lors du fonctionnement du propulseur (2), un système de confinement magnétique (23) de l'enceinte à plasma (20) dudit propulseur ayant la fonction de source d'ions.

**8.** Dispositif (2S) selon l'une quelconque des revendications 1 à 5, dans lequel les cinquièmes bornes (D8, D9) du dispositif comprennent deux bornes d'alimentation en radiofréquence, qui sont destinées à être connectées à deux bornes de sortie d'un générateur radiofréquence (3) de l'ensemble d'alimentation électrique (1), pour remplacer deux bornes (B8, B9) d'une bobine (29) d'excitation de l'enceinte à plasma (20) du propulseur (2), le dispositif comprenant en outre une bobine (27S) et une résistance (28S) de simulation d'enceinte à plasma qui sont connectées en série entre les deux bornes d'alimentation en radiofréquence dudit dispositif, et qui sont destinées à simuler la bobine d'excitation de l'enceinte à plasma du propulseur et un comportement électrique du plasma ayant la fonction de source d'ions lors du fonctionnement du propulseur, et dans lequel l'unité de mesure (19S) est adaptée pour mesurer un courant radiofréquence ($I_{RF}$) qui est reçu par le dispositif (2S) par les deux bornes d'alimentation en radiofréquence (D8, D9), et pour mesurer une tension ($V_{28S}$) qui existe dans la résistance (28S) de simulation d'enceinte à plasma, et pour calculer une valeur de la puissance de décharge ($P_{ion}$) reçue à partir de valeurs mesurées respectivement pour le courant radiofréquence et pour la tension qui existe dans la résistance de simulation d'enceinte à plasma.

**9.** Procédé de test d'un ensemble d'alimentation électrique (1), ledit ensemble d'alimentation électrique étant adapté pour être connecté à un propulseur ionique à grilles (2) pour fournir au propulseur des tensions et courants électriques pendant un fonctionnement dudit propulseur, le procédé comprenant les étapes suivantes :

/1/ collecter au moins un paramètre caractéristique du propulseur (2) ;

/2/ reproduire l'au moins un paramètre caractéristique du propulseur (2) dans un dispositif (2S) qui est conforme à l'une quelconque des revendications précédentes, et configurer le dispositif de sorte que ledit dispositif imite un fonctionnement du propulseur ;

/3/ connecter l'ensemble d'alimentation électrique (1) au dispositif (2S) ;

/4/ activer l'ensemble d'alimentation électrique (1) afin que le dispositif (2S) imite le fonctionnement du propulseur (2) pour ledit ensemble d'alimentation électrique, et réaliser, au moyen de l'ensemble d'alimentation électrique, au moins une mesure d'une tension ou d'un courant électrique qui est fourni au dispositif par ledit ensemble d'alimentation électrique ; et

/5/ d'après un résultat de la mesure, valider un fonctionnement de l'ensemble d'alimentation électrique (1), ou déclarer un dysfonctionnement dudit ensemble d'alimentation électrique.

**10.** Procédé selon la revendication 9, suivant lequel l'au moins un paramètre caractéristique du propulseur (2) qui est collecté à l'étape /1/ comprend une valeur de capacité d'interaction qui existe entre la grille d'écran (24) et la grille d'accélération (25) dudit propulseur, ladite valeur de capacité d'interaction étant déterminée en additionnant les trois contributions suivantes :

- une première contribution qui correspond à des faces respectives de la grille d'écran (24) et la grille d'accélération (25) du propulseur (2) qui sont en vis-à-vis ;

- une deuxième contribution qui correspond à une capacité de frange de la grille d'écran (24) du propulseur (2), existant entre la grille d'accélération (25) et des surfaces latérales de trous de ladite grille d'écran ; et

- une troisième contribution qui correspond à une capacité de frange de la grille d'accélération (25) du propulseur (2), existant entre la grille d'écran (24) et des surfaces latérales de trous de ladite grille d'accélération,

et suivant lequel le dispositif (2S) est dimensionné en attribuant ladite valeur de capacité d'interaction au condensateur ($C_{SAG}$) du dispositif (2S) qui est connecté entre les bornes positive et négative de la seconde source de courant dépendante (17S).

11. Procédé selon la revendication 9 ou 10, suivant lequel l'ensemble d'alimentation électrique (1) comprend un dispositif (18) d'asservissement de la puissance de décharge ($P_{ion}$), ledit dispositif d'asservissement étant conçu pour ajuster ladite puissance de décharge de façon à maintenir constante une valeur de différence entre un courant électrique ($I_{PHV}$) qui entre dans le dispositif (2S) par la première borne (B1 ; C1) et un autre courant électrique ($I_{NHV}$) qui sort du dispositif par la seconde borne (B2 ;C2),

   et suivant lequel l'étape /4/ est exécutée pendant que la valeur de différence est maintenue constante par le dispositif d'asservissement (18),
   et l'étape /4/ comprend d'adopter, par l'ensemble d'alimentation électrique (1), des valeurs variables successives pour la tension électrique négative ($V_{NHV}$) qui sont croissantes alors que la tension électrique positive ($V_{PHV}$) est gardée constante, et une valeur de la puissance de décharge ($P_{ion}$) est mesurée par ledit ensemble d'alimentation électrique pour chaque valeur adoptée pour la tension électrique négative,
   et l'étape /5/ comprend de vérifier un profil de variation des valeurs mesurées pour la puissance de décharge ($P_{ion}$) en fonction des valeurs variables de la tension électrique négative ($V_{NHV}$).

12. Procédé selon la revendication 11, suivant lequel l'ensemble d'alimentation électrique (1) est configuré pour arrêter, à l'étape /4/, une séquence des valeurs variables successives qui sont adoptées pour la tension électrique négative ($V_{NHV}$) si une réduction de la puissance de décharge ($P_{ion}$), par rapport à une valeur maximale de ladite puissance de décharge qui a été atteinte pendant la séquence, devient supérieure à une valeur limite de réduction ($\Delta P_{ion\_limit}$).

13. Procédé selon la revendication 11 ou 12, suivant lequel le dispositif (2S) est conforme à la revendication 5 et une valeur du paramètre supplémentaire de configuration $V_{NHVchange}$ a été entrée dans le dispositif à l'étape /2/,

   et suivant lequel la tension électrique négative ($V_{NHV}$) est variée à l'étape /4/ par l'ensemble d'alimentation électrique (1) en adoptant des valeurs successives qui sont de moins en moins négatives pour ladite tension électrique négative,
   et suivant lequel l'étape /5/ comprend les sous-étapes suivantes :

   /5-1/ déterminer, d'après les valeurs mesurées pour la puissance de décharge ($P_{ion}$), une valeur de seuil ($V_{NHV\_EBS}$) pour la tension électrique négative ($V_{NHV}$) qui correspond à un coude dans une courbe des valeurs mesurées pour ladite puissance de décharge en fonction des valeurs croissantes de la tension électrique négative ($V_{NHV}$), du côté des valeurs les moins négatives de ladite tension électrique négative ; puis
   /5-2/ comparer la valeur de seuil ($V_{NHV\_EBS}$) déterminée à la sous-étape /5-1/ à la valeur du paramètre supplémentaire de configuration $V_{NHVchange}$, et valider le fonctionnement de l'ensemble d'alimentation électrique (1) si ladite valeur de seuil correspond à ladite valeur du paramètre supplémentaire de configuration $V_{NHVchange}$ conformément à un critère de concordance, sinon déclarer le dysfonctionnement de l'ensemble d'alimentation électrique.

14. Procédé selon la revendication 13, suivant lequel le critère de concordance utilisé à la sous-étape /5-2/ est qu'une valeur absolue d'une différence entre la valeur de seuil ($V_{NHV\_EBS}$) déterminée à la sous-étape /5-1/ et la valeur du paramètre supplémentaire de configuration $V_{NHVchange}$, divisée par une valeur absolue dudit paramètre supplémentaire de configuration $V_{NHVchange}$, soit inférieure à 1%.

15. Procédé selon l'une quelconque des revendications 9 à 14, suivant lequel l'au moins un paramètre caractéristique du propulseur (2) et les paramètres de configuration qui sont utilisés pour le dispositif (2S) à l'étape /2/ concernent un propulseur ionique à grilles à décharge continue ou un propulseur ionique à grilles à décharge radiofréquence.

**Patentansprüche**

1. Elektrische Vorrichtung (2S), die vorgesehen ist, sich wie ein gerastertes Ionentriebwerk (2) zu verhalten, wenn die Vorrichtung via Klemmen der Vorrichtung elektrisch mit einer Stromversorgungsanordnung (1) einer Flugsteuerung des Triebwerks verbunden ist, wobei die Vorrichtung zumindest aufweist:

- eine erste Klemme (C1 ; D1) zum Empfangen einer von der Stromversorgungsanordnung (1) bereitgestellten positiven elektrischen Spannung ($V_{PHV}$), wobei die erste Klemme (C1 ; D1) vorgesehen ist, eine Versorgungsklemme (A1; B1) eines Schirmgitters (24) des Triebwerks (2) zu ersetzen;

- eine zweite Klemme (C2; D2) zum Empfangen einer von der Stromversorgungsanordnung (1) bereitgestellten negativen elektrischen Spannung ($V_{NHV}$), wobei die zweite Klemme (C2; D2) vorgesehen ist, eine Versorgungsklemme (A2; B2) eines Beschleunigungsgitters (25) des Triebwerks (2) zu ersetzen;

- eine dritte Klemme (C3; D3) zum Weiterleiten eines aus der Vorrichtung (2S) kommenden Rückkehrstroms ($I_{neutr}$) zu einem gemeinsamen Referenzknoten (CRP) der Stromversorgungsanordnung (1), wobei die dritte Klemme (C3; D3) vorgesehen ist, eine Stromrückkehrklemme (A3; B3) eines Neutralisators (27) des Triebwerks (2) zu ersetzen, dessen Funktion es ist, während eines Betriebs des Triebwerks einen Elektronenfluss zum Neutralisieren eines Ionenstrahls zu erzeugen, wobei der gemeinsame Referenzknoten ein elektrisches Referenzpotential für die positive elektrische Spannung ($V_{PHV}$) und für die negative elektrische Spannung ($V_{NHV}$) bildet;

- eine vierte Klemme (C4; D4) zum Empfangen eines aus der Stromversorgungsanordnung (1) kommenden Neutralisator-Haltestroms ($I_{keeper}$), wobei die vierte Klemme (C4; D4) vorgesehen ist, eine Klemme (A4; B4) eines Haltesystems (272) des Neutralisators (27) des Triebwerks (2) zu ersetzen, dessen Funktion es ist, während des Betriebs des Triebwerks eine Temperatur des Neutralisators (27) zu halten;

- einen Neutralisator-Halten-Simulationswiderstand (25S), der zwischen der dritten (C3; D3) und vierten (C4; D4) Klemme der Vorrichtung (2S) verbunden ist;

- mindestens zwei fünfte Klemmen (C8-C14; D8, D9) zum Empfangen einer von einer Entladungsversorgungsstufe (11; 3) der Stromversorgungsanordnung (1) bereitgestellten Entladungsleistung ($P_{ion}$), wobei die fünften Klemmen (C8-C14; D8, D9) vorgesehen sind, Klemmen (A8-A14; B8, B9) des Triebwerks mindestens teilweise zu ersetzen, die dazu bestimmt sind, die Entladungsleistung zu empfangen, um ein Plasma zu erzeugen, das während des Betriebs des Triebwerks die Funktion einer Ionenquelle hat;

wobei die Vorrichtung **dadurch gekennzeichnet ist, dass** sie ferner aufweist:

- eine Messeinheit (19S), die angeordnet ist, um die empfangene Entladungsleistung ($P_{ion}$) zu messen;
- eine erste abhängige Stromquelle (16S), die eine mit der ersten Klemme (C1 ; D1) der Vorrichtung (2S) verbundene positive Klemme und eine mit der dritten Klemme (C3; D3) der Vorrichtung verbundene negative Klemme aufweist, wobei die erste abhängige Stromquelle vorgesehen ist, einen Strahlstrom (**$I_{beam}$**) zu fixieren, der von der positiven Klemme der ersten abhängigen Stromquelle über die erste abhängige Stromquelle zu der negativen Klemme der ersten abhängigen Stromquelle fließt;
- eine zweite abhängige Stromquelle (17S), die eine mit der ersten Klemme (C1 ; D1) der Vorrichtung (2S) verbundene positive Klemme und eine mit der zweiten Klemme (C2; D2) der Vorrichtung verbundene negative Klemme aufweist, wobei die zweite abhängige Stromquelle vorgesehen ist, einen Beschleunigungsgitterstrom ($I_{NHV}$) zu fixieren, der von der positiven Klemme der zweiten abhängigen Stromquelle über die zweite abhängige Stromquelle zu der negativen Klemme der zweiten abhängigen Stromquelle fließt; und
- einen Kondensator ($C_{SAG}$), der zwischen der positiven und negativen Klemme der zweiten abhängigen Stromquelle (17S) verbunden ist,

wobei die Vorrichtung (2S) konfiguriert ist, um, wenn die Vorrichtung elektrisch versorgt und mit der Stromversorgungsanordnung (1) verbunden ist, den Strahlstrom (**$I_{beam}$**) als Funktion der von der Messeinheit (19S) gemessenen Entladungsleistung ($P_{ion}$) und als Funktion mindestens eines Konfigurationsparameters der Vorrichtung zu bestimmen und ferner den Beschleunigungsgitterstrom ($I_{NHV}$) als Funktion des Strahlstroms (**$I_{beam}$**) und als Funktion mindestens eines anderen Konfigurationsparameters der Vorrichtung zu bestimmen.

2. Vorrichtung (2S) nach Anspruch 1, in welcher der Kondensator ($C_{SAG}$), der zwischen der positiven und negativen Klemme der zweiten abhängigen Stromquelle (17S) verbunden ist, vorgesehen ist, eine Wechselwirkungskapazität zu simulieren, die zwischen dem Schirmgitter (24) und dem Beschleunigungsgitter (25) des Triebwerks (2) vorhanden ist,

und der Kondensator ($C_{SAG}$) einen Kapazitätswert hat, der sich durch Addieren der drei folgenden Beiträge ergibt:

- ein erster Beitrag, der jeweiligen Flächen des Schirmgitters (24) und des Beschleunigungsgitters (25) des Triebwerks (2) entspricht, die sich gegenüberliegen;
- ein zweiter Beitrag, der einer Randkapazität des Schirmgitters (24) des Triebwerks (2) entspricht, die zwischen dem Beschleunigungsgitter (25) und lateralen Oberflächen von Löchern des Schirmgitters vorhanden ist; und
- ein dritter Beitrag, der einer Randkapazität des Beschleunigungsgitters (25) des Triebwerks (2) entspricht, die zwischen dem Schirmgitter (24) und lateralen Oberflächen von Löchern des Beschleunigungsgitters vorhanden ist.

3. Vorrichtung (2S) nach Anspruch 1 oder 2, ferner aufweisend:

- eine elektrische Erdungsklemme (C5; D5), die vorgesehen ist, mit einer elektrischen Erdung (10) der Stromversorgungsanordnung (1) verbunden zu werden, und eine Erdungsklemme (A5; B5) des Triebwerks (2) ersetzt; und
- eine zusätzliche elektrische Quelle (18S), die eine mit der dritten Klemme (C3; D3) der Vorrichtung (2S) verbundene erste Klemme und eine mit der elektrischen Erdungsklemme (C5; D5) der Vorrichtung verbundene zweite Klemme hat, um während eines Betriebs der Vorrichtung einen elektrischen Strom zu erzeugen, der vorgesehen ist, einen Leckstrom ($I_{leak}$) zu imitieren, der während des Betriebs des Triebwerks in dem Triebwerk (2) entsteht, wobei die Vorrichtung konfiguriert ist, um je nach Aktivierungszustand und Deaktivierungszustand der ersten abhängigen Stromquelle (16S) die zusätzliche elektrische Quelle zu aktivieren oder zu deaktivieren.

4. Vorrichtung (2S) nach einem der vorstehenden Ansprüche, aufweisend ferner eine Steuerung (20S) der ersten und zweiten abhängigen Stromquelle,

wobei die Steuerung derart konfiguriert ist, dass die erste abhängige Stromquelle (16S) den Strahlstrom (**$I_{beam}$**) gemäß der ersten Transferfunktion wie folgt fixiert:

$$I_{beam} = K_{beam} * P_{ion},$$

falls die positive elektrische Spannung ($V_{PHV}$), die an der ersten Klemme (C1; D1) der Vorrichtung empfangen wird, größer als eine Ionenextraktionsschwelle $V_{PHVextr}$ ist, und

$$I_{beam} = 0,$$

falls nicht,
wobei $I_{beam}$ den von der ersten abhängigen Stromquelle fixierten Strahlstrom bezeichnet, $P_{ion}$ die von den fünften Klemmen (C8-C14; D8, D9) der Vorrichtung empfangene und von der Messeinheit (19S) gemessene Entladungsleistung bezeichnet, wobei die Ionenextraktionsschwelle $V_{PHVextr}$ ein erster Konfigurationsparameter der Vorrichtung und $K_{beam}$ ein Koeffizient ist,
und die Steuerung (20S) außerdem derart konfiguriert ist, dass die zweite abhängige Stromquelle (17S) den Beschleunigungsgitterstrom ($I_{NHV}$) gemäß der zweiten Transferfunktion wie folgt fixiert: $I_{NHV} = I_{beam}/\beta$, wobei $I_{NHV}$ den von der zweiten abhängigen Stromquelle fixierten Beschleunigungsgitterstrom bezeichnet und $\beta$ ein anderer Koeffizient ist, der einen zweiten Konfigurationsparameter der Vorrichtung bildet.

5. Vorrichtung (2S) nach Anspruch 4, in welcher die Steuerung (20S) der ersten und zweiten abhängigen Stromquelle ferner konfiguriert ist, um den Koeffizienten $K_{beam}$ gemäß der folgenden Formel zu bestimmen:

$$K_{beam} = K_{beam0} * \{1 + [exp(V_{NHV} - V_{NHVchange})]/100\},$$

falls der Koeffizient $K_{beam}$ kleiner als ein Koeffizient-Maximalwert $K_{beammax}$ ist, und

$$K_{beam} = K_{beammax},$$

falls nicht,
wobei exp() eine Exponentialfunktion bezeichnet,
$V_{NHV}$ die an der zweiten Klemme (C2; D2) der Vorrichtung empfangene negative elektrische Spannung, ausgedrückt in Volt, ist, und
der Koeffizienten-Maximalwert $K_{beammax}$ sowie $K_{beam0}$ und $V_{NHVchange}$, ausgedrückt in Volt, zusätzliche Konfigurationsparameter der Vorrichtung sind.

6. Vorrichtung (2S) nach einem der Ansprüche 1 bis 5, in welcher die fünften Klemmen (C8-C14) zumindest aufweisen:

- eine Entladungsstrom-Versorgungsklemme (C14), die vorgesehen ist, eine Klemme (A14) einer Anode (21) einer Plasmakammer (20) des Triebwerks (2) zu ersetzen, in der das Plasma, das die Funktion einer Ionenquelle hat, während des Betriebs des Triebwerks erzeugt wird; und
- eine Stromrückkehrklemme (C11), die vorgesehen ist, eine Klemme (A11) des Triebwerks zu ersetzen, die einen Kathodenrückstrom ($I_{return\_cath}$), der aus einer Kathode (22) der Plasmakammer (20) des Triebwerks kommt, zu der Stromversorgungsanordnung (1) weiterleitet,
wobei die Vorrichtung (2S) ferner aufweist:

- einen die Plasmakammer des Triebwerks simulierenden Plasmakammer-Simulationswiderstand (21S), der zwischen der Entladungsstrom-Versorgungsklemme (C14) und der Stromrückkehrklemme (C11) verbunden ist,

und wobei die Messeinheit (19S) angepasst ist, um einen Entladungsstrom ($I_d$), der von der Vorrichtung (2S) über die Entladungsstrom-Versorgungsklemme (C14) empfangen wird, zu messen und um eine Spannung ($V_{anode}$), die zwischen Enden des Plasmakammer-Simulationswiderstands (21S) vorhanden ist, zu messen und um ausgehend von Werten, die jeweils für den Entladungsstrom und für die Spannung, die zwischen Enden des Plasmakammer-Simulationswiderstands (21S) vorhanden ist, gemessen werden, einen Wert der empfangenen Entladungsleistung ($P_{ion}$) zu berechnen.

7. Vorrichtung (2S) nach Anspruch 6, in welcher die fünften Klemmen (C8-C14) ferner aufweisen:

- zwei Kathodenheizung-Simulationsklemmen (C9, C10), die über einen zusätzlichen ersten Widerstand (22S) im Innern der Vorrichtung (2S) miteinander verbunden sind und vorgesehen sind, zwei Klemmen (A9, A10) des Triebwerks (2) zu ersetzen, die dazu bestimmt sind, während des Betriebs des Triebwerks einen Heizungswiderstand (26) der Kathode (22) der Plasmakammer (20) des Triebwerks, die die Funktion einer Ionenquelle hat, zu versorgen;
- eine Kathoden-Simulationsklemme (C8), die über einen zweiten zusätzlichen Widerstand (23S) im Innern der Vorrichtung (2S) mit der Stromrückkehrklemme (C11) verbunden ist und vorgesehen ist, eine Klemme (A8) des Triebwerks (2) zu ersetzen, die dazu bestimmt ist, während des Betriebs des Triebwerks ein Haltesystem (220), das zusätzlich zur Anode (21) der Plasmakammer mit der Kathode (22) der Plasmakammer (20) des Triebwerks assoziiert ist, mit einem Kathodenhaltestrom ($I_{kee-per\_cath}$) zu versorgen, und die Funktion hat, während des Betriebs des Triebwerks eine Temperatur der Kathode zu halten; und
- zwei Magnetischer-Einschluss-Simulationsklemmen (C12, C13), die im Innern der Vorrichtung (2S) über eine Spule (24S), die mit einem ferromagnetischen Element assoziiert ist, miteinander verbunden sind und vorgesehen sind, zwei Klemmen (A12, A13) des Triebwerks (2) zu ersetzen, die dazu bestimmt sind, während des Betriebs des Triebwerks (2) ein magnetisches Einschluss-System (23) der Plasmakammer (20) des Triebwerks, die die Funktion einer Ionenquelle hat, zu versorgen.

8. Vorrichtung (2S) nach einem der Ansprüche 1 bis 5, in welcher die fünften Klemmen (D8, D9) der Vorrichtung zwei Hochfrequenzversorgung-Klemmen aufweisen, die vorgesehen sind, mit zwei Ausgangsklemmen eines Hochfrequenz-Generators (3) der Stromversorgungsanordnung (1) verbunden zu werden, um zwei Klemmen (B8, B9) einer Erregungsspule (29) der Plasmakammer (20) des Triebwerks (2) zu ersetzen, wobei die Vorrichtung ferner eine Spule (27S) und einen Plasmakammer-Simulationswiderstand (28S) aufweist, die zwischen den zwei Hochfrequenzversorgung-Klemmen der Vorrichtung in Reihe verbunden sind und die vorgesehen sind, die Erregungsspule der Plasmakammer des Triebwerks und ein elektrisches Verhalten des Plasmas, das während des Betriebs des Triebwerks die Funktion einer Ionenquelle hat, zu simulieren,
und in welcher die Messeinheit (19S) angepasst ist, um einen Hochfrequenzstrom ($I_{RF}$), der von der Vorrichtung (2S) über die zwei Hochfrequenzversorgung-Klemmen (D8, D9) empfangen wird, zu messen und um eine Spannung ($V_{28S}$), die in dem Plasmakammer-Simulationswiderstand (28S) vorhanden ist, zu messen und um ausgehend von Werten, die jeweils für den Hochfrequenzstrom und für die Spannung, die in dem Plasmakammer-Simulationswiderstand (28S) vorhanden ist, gemessen werden, einen Wert der empfangenen Entladungsleistung ($P_{ion}$) zu berechnen.

9. Verfahren zum Testen einer Stromversorgungsanordnung (1), wobei die Stromversorgungsanordnung angepasst ist, um mit einem gerasterten Ionentriebwerk (2) verbunden zu werden, um dem Triebwerk während eines Betriebs des Triebwerks elektrische Spannungen und Ströme bereitzustellen, wobei das Verfahren die folgenden Schritte aufweist:

/1/ Sammeln mindestens eines charakteristischen Parameters des Triebwerks (2);

/2/ Nachbilden des mindestens einen charakteristischen Parameters des Triebwerks (2) in einer Vorrichtung (2S), die einem der vorstehenden Ansprüche entspricht, und Konfigurieren der Vorrichtung derart, dass die Vorrichtung einen Betrieb des Triebwerks imitiert;

/3/ Verbinden der Stromversorgungsanordnung (1) mit der Vorrichtung (2S);

/4/ Aktivieren der Stromversorgungsanordnung (1), damit die Vorrichtung (2S) den Betrieb des Triebwerks (2) für die Stromversorgungsanordnung imitiert, und Durchführen mindestens einer Messung einer elektrischen Spannung oder eines elektrischen Stroms, die oder der der Vorrichtung von der Stromversorgungsanordnung bereitgestellt wird, mithilfe der Stromversorgungsanordnung; und

/5/ je nach Ergebnis der Messung, Validieren eines Betriebs der Stromversorgungsanordnung (2) oder Erklären eines Fehlbetriebs der Stromversorgungsanordnung.

10. Verfahren nach Anspruch 9, gemäß welchem der mindestens eine charakteristische Parameter des Triebwerks (2), der in Schritt /1/ gesammelt wird, einen Wert einer Wechselwirkungskapazität aufweist, die zwischen dem Schirmgitter (24) und dem Beschleunigungsgitter (25) des Triebwerks vorhanden ist, wobei der Wert der Wechselwirkungskapazität sich durch Addieren der drei folgenden Beiträge ergibt:

- ein erster Beitrag, der jeweiligen Flächen des Schirmgitters (24) und des Beschleunigungsgitters (25) des Triebwerks (2) entspricht, die sich gegenüberliegen;
- ein zweiter Beitrag, der einer Randkapazität des Schirmgitters (24) des Triebwerks (2) entspricht, die zwischen dem Beschleunigungsgitter (25) und lateralen Oberflächen von Löchern des Schirmgitters vorhanden ist; und
- ein dritter Beitrag, der einer Randkapazität des Beschleunigungsgitters (25) des Triebwerks (2) entspricht, die zwischen dem Schirmgitter (24) und lateralen Oberflächen von Löchern des Beschleunigungsgitters vorhanden ist,

und gemäß welchem die Vorrichtung (2S) dimensioniert wird, indem dem Kondensator ($C_{SAG}$) der Vorrichtung (2S), der zwischen der positiven und negativen Klemme der zweiten abhängigen Stromquelle (17S) verbunden ist, der Wert der Wechselwirkungskapazität zugeteilt wird.

11. Verfahren nach Anspruch 9 oder 10, gemäß welchem die Stromversorgungsanordnung (1) eine Regelungsvorrichtung (18) zur Regelung der Entladungsleistung ($P_{ion}$) aufweist, wobei die Regelungsvorrichtung konzipiert ist, um die Entladungsleistung derart anzupassen, dass ein Differenzwert zwischen einem elektrischen Strom ($I_{PHV}$), der über die erste Klemme (B1; C1) in die Vorrichtung (2S) eintritt, und einem anderen elektrischen Strom ($I_{NHV}$), der über die zweite Klemme (B2; C2) aus der Vorrichtung austritt, konstant ist,

und gemäß welchem der Schritt /4/ ausgeführt wird, während der Differenzwert von der Regelungsvorrichtung (18) konstant gehalten wird,

und der Schritt /4/ aufweist: Erlauben der Stromversorgungsanordnung (1), sukzessive sich erhöhende variable Werte für die negative elektrische Spannung ($V_{NHV}$) anzunehmen, während die positive elektrische Spannung ($V_{PHV}$) konstant gehalten wird und von der Stromversorgungsanordnung für jeden angenommenen Wert der negativen elektrischen Spannung ein Wert der Entladungsleistung ($P_{ion}$) gemessen wird,

und der Schritt /5/ aufweist: Verifizieren eines Variationsprofils der für die Entladungsleistung ($P_{ion}$) gemessenen Werte als Funktion der variablen Werte der negativen elektrischen Spannung ($V_{NHV}$).

12. Verfahren nach Anspruch 11, gemäß welchem die Stromversorgungsanordnung (1) konfiguriert ist, um im Schritt /4/ eine Sequenz der sukzessiven variablen Werte, die für die negative elektrische Spannung ($V_{NHV}$) angenommen werden, zu stoppen, wenn eine Verringerung der Entladungsleistung ($P_{ion}$) bezüglich eines Maximalwerts der Entladungsleistung, der während der Sequenz erreicht worden ist, größer als ein Verringerungsgrenzwert ($\Delta P_{ion\_limit}$) ist.

13. Verfahren nach Anspruch 11 oder 12, gemäß welchem die Vorrichtung (2S) dem Anspruch 5 entspricht und im Schritt /2/ ein Wert des zusätzlichen Konfigurationsparameters $V_{NHVchange}$ in die Vorrichtung eingegeben worden ist,

und gemäß welchem im Schritt /4/ die Stromversorgungsanordnung (1) durch Annehmen von sukzessiven Werten, die für die negative elektrische Spannung immer weniger negativ sind, die negative elektrische Spannung ($V_{NHV}$) variiert,

und gemäß welchem der Schritt /5/ die folgenden Teilschritte aufweist:

/5-1/ gemäß den für die Entladungsleistung ($P_{ion}$) gemessenen Werten, Bestimmen eines Schwellenwerts

($V_{NHV\_EBS}$) für die negative elektrische Spannung ($V_{NHV}$), der einer Krümmung in einer Kurve der für die Entladungsleistung gemessenen Werte als Funktion der sich erhöhenden Werte der negativen elektrischen Spannung ($V_{NHV}$) auf der Seite der am wenigsten negativen Werte der negativen elektrischen Spannung entspricht; dann

/5-2/ Vergleichen des im Teilschritt /5-1/ bestimmten Schwellenwerts ($V_{NHV\_EBS}$) mit dem zusätzlichen Konfigurationsparameter $V_{NHVchange}$ und Validieren des Betriebs der Stromversorgungsanordnung (1), falls der Schwellenwert gemäß einem Übereinstimmungskriterium dem zusätzlichen Konfigurationsparameter $V_{NHVchange}$ entspricht, falls nicht, Erklären eines Fehlbetriebs der Stromversorgungsanordnung.

14. Verfahren nach Anspruch 13, gemäß welchem das im Teilschritt /5-2/ verwendete Übereinstimmungskriterium ist, dass ein Absolutwert einer Differenz zwischen dem im Teilschritt /5-1/ bestimmten Schwellenwert ($V_{NHV\_EBS}$) und dem Wert des zusätzlichen Konfigurationsparameters $V_{NHVchange}$, geteilt durch einen Absolutwert des zusätzlichen Konfigurationsparameters $V_{NHVchange}$, kleiner als 1% ist.

15. Verfahren nach einem der Ansprüche 9 bis 14, gemäß welchem der mindestens eine charakteristische Parameter des Triebwerks (2) und die Konfigurationsparameter, die im Schritt /2/ für die Vorrichtung (2S) verwendet werden, sich auf ein gerastertes Ionentriebwerk mit kontinuierlicher Entladung oder ein gerastertes Ionentriebwerk mit Hochfrequenzentladung beziehen.

**Claims**

1. An electrical device (2S) intended to behave as a gridded ion thruster (2) when the device is electrically connected, by terminals of said device, to an electric power supply assembly (1) for driving the thruster, the device comprising at least:

   - a first terminal (C1; D1) to receive a positive electric voltage ($V_{PHV}$) provided by the electric power supply assembly (1), and intended to replace a power supply terminal (A1; B1) of a screen grid (24) of the thruster (2);
   - a second terminal (C2; D2) to receive a negative electric voltage ($V_{NHV}$) provided by the electric power supply assembly (1), and intended to replace a power supply terminal (A2; B2) of an acceleration grid (25) of the thruster (2);
   - a third terminal (C3; D3) to transmit, to a common reference node (CRP) of the electric power supply assembly (1), a return current ($I_{neutr}$) from the device (2S), and intended to replace a current return terminal (A3; B3) of a neutraliser (27) of the thruster (2) having a function of generating an ion beam neutralisation electron flow during an operation of the thruster, the common reference node forming an electric potential reference for the positive electric voltage ($V_{PHV}$) and for the negative electric voltage ($V_{NHV}$);
   - a fourth terminal (C4; D4) to receive a neutraliser keeper current ($I_{keeper}$) from the electric power supply assembly (1), and intended to replace a terminal (A4; B4) of a keeper system (272) of the neutraliser (27) of the thruster (2) having a function of keeping a temperature of said neutraliser during the operation of the thruster;
   - a neutraliser keeper simulation resistor (25S), which is connected between the third (C3; D3) and fourth (C4; D4) terminals of the device (2S);
   - at least two fifth terminals (C8-C14; D8, D9) to receive a discharge power ($P_{ion}$) that is provided by a discharge power supply stage (11; 3) of the electric power supply assembly (1), and intended to replace at least in part terminals (A8-A14; B8, B9) of the thruster (2) that are dedicated to receiving the discharge power to generate a plasma having an ion source function during the operation of the thruster;

   the device being **characterised in that** it further comprises:

   - a measurement unit (19S), arranged to measure the discharge power ($P_{ion}$) received;
   - a first dependent current source (16S), which has a positive terminal connected to the first terminal (C1; D1) of the device (2S) and a negative terminal connected to the third terminal (C3; D3) of said device, the first dependent current source being to set a beam current ($I_{beam}$) that flows through said first dependent current source from the positive terminal of said first dependent current source to the negative terminal of said first dependent current source;
   - a second dependent current source (17S), which has a positive terminal connected to the first terminal (C1; D1) of the device (2S) and a negative terminal connected to the second terminal (C2; D2) of said device, the second dependent current source being to set an acceleration grid current ($I_{NHV}$) that flows through said second dependent current source from the positive terminal of said second dependent current source to the negative terminal of said second dependent current source; and

- a capacitor ($C_{SAG}$), which is connected between the positive and negative terminals of the second dependent current source (17S),

the device (2S) being configured to determine, when the device is electrically powered and connected to the electric power supply assembly (1), the beam current ($I_{beam}$) depending on the discharge power ($P_{ion}$) measured by the measurement unit (19S) and depending on at least one configuration parameter of the device, and to further determine the acceleration grid current ($I_{NHV}$) depending on the beam current ($I_{beam}$) and depending on at least one other configuration parameter of the device.

2. The device (2S) according to claim 1, wherein the capacitor ($C_{SAG}$) which is connected between the positive and negative terminals of the second dependent current source (17S), is to simulate an interaction capacitance that exists between the screen grid (24) and the acceleration grid (25) of the thruster (2),
and said capacitor ($C_{SAG}$) has a capacitance value determined by adding the following three contributions:

- a first contribution that corresponds to respective faces of the screen grid (24) and the acceleration grid (25) of the thruster (2) that are facing one another;
- a second contribution that corresponds to a fringe capacitance of the screen grid (24) of the thruster (2), existing between the acceleration grid (25) and side surfaces of holes of said screen grid; and
- a third contribution that corresponds to a fringe capacitance of the acceleration grid (25) of the thruster (2), existing between the screen grid (24) and side surfaces of holes of said acceleration grid.

3. The device (2S) according to claim 1 or 2, further comprising:

- an electrical ground terminal (C5; D5), which is to be connected to an electrical ground (10) of the electric power supply assembly (1) instead of an electrical ground terminal (A5; B5) of the thruster (2); and
- an additional electrical source (18S), which has a first terminal connected to the third terminal (C3; D3) of the device (2S), and a second terminal connected to the electrical ground terminal (C5; D5) of said device, in order to produce, during an operation of the device, an electric current to imitate a leakage current ($I_{leak}$) that occurs in the thruster (2) during operation of said thruster, the device being configured to activate or deactivate the additional electrical source in accordance with an activation or deactivation state, respectively, of the first dependent current source (16S).

4. The device (2S) according to any of the preceding claims, further comprising a controller (20S) of the first and second dependent current sources, the controller being configured such that the first dependent current source (16S) sets the beam current ($I_{beam}$) in accordance with the following first transfer function: $I_{beam} = K_{beam} \cdot P_{ion}$ if the positive electric voltage ($V_{PHV}$) that is received on the first terminal (C1; D1) of the device is greater than an ion extraction threshold $V_{PHVextr}$, and $I_{beam} = 0$ A otherwise, where $I_{beam}$ denotes the beam current set by said first dependent current source, $P_{ion}$ denotes the discharge power received by the fifth terminals (C8-C14; D8, D9) of the device and measured by the measurement unit (19S), the ion extraction threshold $V_{PHVextr}$ being a first configuration parameter of the device, and $K_{beam}$ being a coefficient,
and the controller (20S) being also configured such that the second dependent current source (17S) sets the acceleration grid current ($I_{NHV}$) in accordance with the following second transfer function: $I_{NHV} = I_{beam}/\beta$, where $I_{NHV}$ denotes the acceleration grid current set by said second dependent current source and $\beta$ is another coefficient that constitutes a second configuration parameter of the device.

5. The device (2S) according to claim 4, wherein the controller (20S) of the first and second dependent current sources is further configured to determine the coefficient $K_{beam}$ according to the following formula: $K_{beam} = K_{beam0} \cdot \{1+[\exp(V_{NHV} - V_{NHVchange})]/100\}$ if said coefficient $K_{beam}$ is less than a maximum coefficient value $K_{beammax}$, and $K_{beam} = K_{beammax}$ otherwise, where exp[ ] denotes an exponential function, $V_{NHV}$ is the negative electric voltage that is received on the second terminal (C2; D2) of the device, expressed in volts, and the maximum coefficient value $K_{beammax}$, as well as $K_{beam0}$ and $V_{NHVchange}$ expressed in volts are additional configuration parameters of the device.

6. The device (2S) according to any of claims 1 to 5, wherein the fifth terminals (C8-C14) comprise at least:

- one discharge current supply terminal (C14), to replace a terminal (A14) of an anode (21) of a plasma enclosure (20) of the thruster (2) where the plasma having the ion source function is generated during the operation of the thruster; and
- one current return terminal (C11), to replace a terminal (A11) of the thruster (2) that transmits, to the electric power supply assembly (1), a cathode return current ($I_{return\_cath}$) from a cathode (22) of the plasma enclosure (20) of the thruster,
the device (2S) further comprising:

- a resistor for simulating the plasma enclosure of the thruster (21S), which is connected between the discharge current power terminal (C14) and the current return terminal (C11),

and the measurement unit (19S) being adapted to measure a discharge current ($I_d$) which is received by the device (2S) by the discharge current power terminal (C14), and to measure a voltage ($V_{anode}$) which exists between ends of the resistor for simulating the plasma enclosure of the thruster (21S), and to calculate a value of the discharge power ($P_{ion}$) received from values measured respectively for the discharge current and for the voltage that exists between the ends of the resistor for simulating the plasma enclosure of the thruster.

7. The device (2S) of claim 6, wherein the fifth terminals (C8-C14) further comprise:

- two cathode heating simulation terminals (C9, C10), connected to each other by a first additional resistor (22S) inside the device (2S), and intended to replace two terminals (A9, A10) of the thruster (2) which are dedicated to supplying, during the operation of the thruster, a heating resistor (26) of the cathode (22) of the plasma enclosure (20) of said thruster having the ion source function;
- a cathode simulation terminal (C8), connected to the current return terminal (C11) by a second additional resistor (23S) inside the device (2S), and intended to replace a terminal (A8) of the thruster (2) which is dedicated to supplying, with a cathode keeper current ($I_{keeper\_cath}$) during the operation of said thruster, a keeper system (220) associated with the cathode (22) of the plasma enclosure (20) of the thruster, additionally to the anode (21) of said plasma enclosure and having a function of maintaining a temperature of the cathode during the operation of the thruster; and
- two magnetic containment simulation terminals (C12, C13), connected to each other inside the device (2S) by a coil (24S) which is associated with a ferromagnetic element, and intended to replace two terminals (A12, A13) of the thruster (2) which are dedicated to supplying, during the operation of the thruster (2), a magnetic containment system (23) of the plasma enclosure (20) of said thruster having the ion source function.

8. The device (2S) according to any of claims 1 to 5, wherein the fifth terminals (D8, D9) of the device comprise two radiofrequency power supply terminals, which are to be connected to two output terminals of a radiofrequency generator (3) of the electric power supply assembly (1), to replace two terminals (B8, B9) of an excitation coil (29) of the plasma enclosure (20) of the thruster (2), the device further comprising a coil (27S) and a plasma enclosure simulation resistor (28S) that are connected in series between the two radiofrequency power supply terminals of said device, and which are to simulate the excitation coil of the plasma enclosure of the thruster and an electrical behaviour of the plasma having the ion source function during the operation of the thruster,
and wherein the measurement unit (19S) is adapted to measure a radiofrequency current ($I_{RF}$) that is received by the device (2S) by the two radiofrequency power supply terminals (D8, D9), and to measure a voltage ($V_{28S}$) that exists in the plasma enclosure simulation resistor (28S), and to calculate a value of the discharge power ($P_{ion}$) received from values measured respectively for the radiofrequency current and for the voltage that exists in the plasma enclosure simulation resistor.

9. A method for testing an electric power supply assembly (1), said electric power supply assembly being adapted to be connected to a gridded ion thruster (2) to provide the thruster with electric voltages and currents during an operation of said thruster, the method comprising the following steps of:

/1/ collecting at least one characteristic parameter of the thruster (2);
/2/ reproducing the at least one characteristic parameter of the thruster (2) in a device (2S) that is in accordance with any of the preceding claims, and configuring the device so that said device imitates an operation of the thruster;
/3/ connecting the electric power supply assembly (1) to the device (2S);
/4/ activating the electric power supply assembly (1) so that the device (2S) imitates the operation of the thruster (2) for said electric power supply assembly, and performing, by means of the electric power supply assembly, at least one measurement of an electric voltage or current that is provided to the device by said electric power supply assembly; and
/5/ based on a measurement result, validating an operation of the electric power supply assembly (1), or stating a malfunction of said electric power supply assembly.

10. The method according to claim 9, wherein the at least one characteristic parameter of the thruster (2) that is collected in step /1/ comprises an interaction capacitance value that exists between the screen grid (24) and the acceleration grid (25) of said thruster, said interaction capacitance value being determined by adding the following three contributions:

    - a first contribution that corresponds to respective faces of the screen grid (24) and the acceleration grid (25) of the thruster (2) that are facing one another;
    - a second contribution that corresponds to a fringe capacitance of the screen grid (24) of the thruster (2), existing between the acceleration grid (25) and side surfaces of holes of said screen grid; and
    - a third contribution that corresponds to a fringe capacitance of the acceleration grid (25) of the thruster (2), existing between the screen grid (24) and side surfaces of holes of said acceleration grid,

and wherein the device (2S) is sized by assigning said interaction capacitance value to the capacitor ($C_{SAG}$) of the device (2S) which is connected between the positive and negative terminals of the second dependent current source (17S).

11. The method according to claim 9 or 10, wherein the electric power supply assembly (1) comprises a servo device (18) for servocontrolling the discharge power ($P_{ion}$), said servo device being designed to adjust said discharge power so as to keep constant a difference value between an electric current ($I_{PHV}$) entering the device (2S) through the first terminal (B1; C1) and another electric current ($I_{NHV}$) exiting the device through the second terminal (B2; C2),

and wherein step /4/ is executed while the difference value is kept constant by the servo device (18),
and step /4/ comprises adopting, by the electric power supply assembly (1), successive variable values for the negative electric voltage ($V_{NHV}$) which are increasing while the positive electric voltage ($V_{PHV}$) is kept constant,
and a value of the discharge power ($P_{ion}$) is measured by said electric power supply assembly for each value adopted for the negative electric voltage,
and step /5/ comprises checking a variation profile of the values measured for the discharge power ($P_{ion}$) as a function of the variable values of the negative electric voltage ($V_{NHV}$).

12. The method according to claim 11, wherein the electric power supply assembly (1) is configured to stop, in step /4/, a sequence of successive variable values that are adopted for the negative electric voltage ($V_{NHV}$) if a reduction in the discharge power ($P_{ion}$), relative to a maximum value of said discharge power that has been achieved during the sequence, becomes greater than a reduction limit value ($\Delta P_{ion\_limit}$).

13. The method according to claim 11 or 12, wherein the device (2S) is in accordance with claim 5 and a value of the additional configuration parameter $V_{NHVchange}$ has been input into the device in step /2/,

and wherein the negative electric voltage ($V_{NHV}$) is varied in step /4/ by the electric power supply assembly (1) by adopting successive values that are less and less negative for said negative electric voltage,
and wherein step /5/ comprises the following sub-steps of:

    /5-1/ determining, based on the values measured for the discharge power ($P_{ion}$), a threshold value ($V_{NHV\_EBS}$) for the negative electric voltage ($V_{NHV}$) that corresponds to a bend in a curve of the values measured for said discharge power as a function of the increasing values of the negative electric voltage ($V_{NHV}$), on the side of the least negative values of said negative electric voltage; then
    /5-2/ comparing the threshold value ($V_{NHV\_EBS}$) determined in sub-step /5-1/ with the value of the additional configuration parameter $V_{NHVchange}$, and validating the operation of the electric power supply assembly (1) if said threshold value corresponds to said value of the additional configuration parameter $V_{NHVchange}$ in accordance with a matching criterion, otherwise stating the malfunction of the electric power supply assembly.

14. The method according to claim 13, wherein the matching criterion used in sub-step /5-2/ is that an absolute value of a difference between the threshold value ($V_{NHV\_EBS}$) determined in sub-step /5-1/ and the value of the additional configuration parameter $V_{NHVchange}$, divided by an absolute value of said additional configuration parameter $V_{NHVchange}$, is less than 1%.

15. The method according to any of claims 9 to 14, wherein the at least one characteristic parameter of the thruster (2) and the configuration parameters that are used for the device (2S) in step /2/ relate to a continuous discharge gridded ion thruster or a radiofrequency ion thruster.

FIG. 1

**FIG. 2**

FIG. 3

FIG. 4

**FIG. 5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6964396 B2

- CN 104330661 A